# EUROPEAN PATENT SPECIFICATION

(11) **EP 3 667 189 B1**
(45) Date of publication and mention of the grant of the patent: **02.03.2022**
(21) Application number: 18843222.3
(22) Date of filing: 06.08.2018
(51) Int. Cl.: F24F 1/24, F24F 1/22, F24F 13/20, F24F 13/30, F28D 15/02, H01L 23/427, H01L 23/467, H05K 7/20, F28F 3/02

(54) **OUTDOOR UNIT FOR REFRIGERATION DEVICE**
AUSSENEINHEIT FÜR EINE KÜHLVORRICHTUNG
UNITÉ EXTÉRIEURE POUR DISPOSITIF DE RÉFRIGÉRATION

(30) Priority: 09.08.2017 JP 2017154720
(43) Date of publication of application: 17.06.2020
(73) Proprietor: Daikin Industries, Ltd., Osaka-shi, Osaka 530-8323 (JP)
(72) Inventor: KUROKAWA, Miho, Kita-ku, Osaka-shi Osaka 530-8323 (JP); KAMITANI, Shigeki, Kita-ku, Osaka-shi Osaka 530-8323 (JP); KOSHIJI, Taichi, Kita-ku, Osaka-shi Osaka 530-8323 (JP); OHTA, Shougo, Kita-ku, Osaka-shi Osaka 530-8323 (JP); DOI, Hirotaka, Kita-ku, Osaka-shi Osaka 530-8323 (JP)
(74) Representative: Conti, Marco
(86) International application number: PCT/JP2018/029404
(87) International publication number: WO 2019/031449

(56) References cited:
- EP-A1- 2 481 995
- WO-A1-2012/081055
- JP-A- S 643 497
- JP-A- 2000 104 951
- JP-A- 2001 317 767
- JP-A- 2002 164 607
- JP-A- 2007 218 534
- JP-A- 2009 198 173
- JP-A- 2015 215 149
- JP-U- S49 134 942
- US-A1- 2007 058 347

## Description

### TECHNICAL FIELD

The present invention relates to an outdoor unit for a refrigeration apparatus.

### BACKGROUND ART

In a popular outdoor unit for a refrigeration apparatus, a fan provides an air flow to cool an electric component (a heat generating component) configured to generate heat when being energized. It is considered that, for example, a power device such as an insulated gate bipolar transistor (IGBT) or a power module including the power device is particularly larger in heating value than other heat generating components; therefore, the power device or power module is unsatisfactorily cooled only by the air flow from the viewpoint of ensuring reliability. It is therefore considered that such a heat generating component is cooled by a heat pipe in which a coolant is sealed, in order to increase a cooling value, like an outdoor unit for an air conditioning apparatus disclosed in, for example, Patent Literature 1 (JP 2006-266547 A). According to the technique disclosed in Patent Literature 1, a heat pipe is thermally connected to a heat generating component and a heat radiating fin to cool the heat generating component. Other outdoor units for refrigeration apparatus are disclosed in patent documents EP2481995A1 which discloses the features of the preamble of claim 1 ,US2007/058347A1 and JP2015215149A.

### SUMMARY OF THE INVENTION

### <Technical Problem>

According to the technique disclosed in Patent Literature 1, the heat pipe is disposed in a blowing space (a space where a main flow path of an air flow provided by a fan are formed), so that the heat pipe may undergo decrease in weather resistance. Specifically, it is supposed that the heat pipe undergoes deformation, damage, and electrolytic corrosion because of contact with another device, and also undergoes deterioration, corrosion, and alteration because of direct exposure to an air flow. In this respect, as to an outdoor unit installed outdoors, a heat pipe may particularly undergo decrease in weather resistance. The deformation, damage, electrolytic corrosion, deterioration, corrosion, and alteration of the heat pipe hinder the heat pipe from exerting its satisfactory cooling performance, which may cause the heat pipe to unsatisfactorily cool a heat generating component. In other words, such a situation may cause decrease in reliability.

Hence, the present invention provides an outdoor unit for a refrigeration apparatus, the outdoor unit being capable of suppressing decrease in reliability in cooling a heat generating component using a heat pipe.

### <Solutions to Problem>

The invention is defined in claim 1. The dependent claims define preferred embodiments of the invention.

According to a first aspect of the present invention, an outdoor unit for a refrigeration apparatus includes a fan, a casing, a first heat generating component, a first board, an electric component box, and a first cooler. The fan is configured to provide an air flow. The casing houses therein the fan. The casing has a blow-out port. The blow-out port is an opening through which the air flow are blown. The first heat generating component is configured to generate heat when being energized. The first heat generating component is mounted on the first board. The electric component box houses therein the first board. The first cooler is configured to cool the first heat generating component. The first cooler is thermally connected to the first heat generating component. The first cooler includes a heat pipe, a plurality of first heat radiating fins, and a main body. A coolant is sealed in the heat pipe. The coolant is used for heat exchange with the first heat generating component. The first heat radiating fins are located on a flow path of the air flow. The first heat radiating fins are configured to exchange heat with the air flow. The main body is interposed between the heat pipe and the first heat radiating fins. The main body thermally connects the heat pipe to the first heat radiating fins. The heat pipe is located in the electric component box. The heat pipe is adjacent to the first heat generating component.

In the outdoor unit according to the first aspect of the present invention, the first cooler configured to cool the first heat generating component includes the heat pipe in which the coolant for heat exchange with the first heat generating component is sealed. In addition, the heat pipe is located in the electric component box, and is adjacent to the first heat generating component. In other words, the heat pipe configured to cool the electric component is located in the electric component box. The heat pipe is thus shielded from a space (e.g., a blowing space) outside the electric component box. As a result, this configuration suppresses a situation in which the heat pipe undergoes deformation, damage, and electrolytic corrosion because of contact with another device, and also undergoes deterioration, corrosion, and alteration because of direct exposure to an air flow. This configuration thus suppresses decrease in cooling performance of the heat pipe because of decrease in weather resistance of the heat pipe. This configuration therefore suppresses decrease in reliability.

The "first heat generating component" used herein refers to, for example, a power device, such as an insulated gate bipolar transistor (IGBT) having a larger heating value or a power module including the power device.

The "main body" used herein refers to a portion interposed between the heat pipe and the first heat radiating fins. For example, the "main body" used herein refers to a portion holding the heat pipe and/or the first heat radiating fins.

The state "thermally connected" used herein is not limited to a case where the "first cooler" and the "first heat generating component" are in direct contact with each other as long as the "first cooler" and the "first heat generating component" are disposed in a heatexchangeable state. For example, the state "thermally connected" involves a case where the "first cooler" and the "first heat generating component" are disposed with a heat-transmissive object interposed therebetween, and a case where the "first cooler" and the "first heat generating component" are disposed with a clearance formed therebetween.

The state "located in the electric component box" used herein refers to a state in which the "heat pipe" does not extend from a space inside the electric component box to a space outside the lectric component box (i.e., a space where an air flow flows). In other words, the "heat pipe" may be regarded as being "located in the electric component box" as long as the "heat pipe" is not located in the space outside the electric component box while being exposed to an air flow, irrespective of a configuration of the "electric component box". For example, even when the electric component box has an opening communicating with the space outside the electric component box (i.e., even when the electric component box is not enclosed), the "heat pipe" may be regarded as being "located in the electric component box" as long as the heat pipe is not directly exposed to an air flow at a position outside the electric component box in such a manner that the heat pipe protrudes out of electric component box through the opening.

In the outdoor unit according to the invention, the electric component box has a first opening. The first heat radiating fins are exposed from the first opening. The main body has an area that is equal to or more than an area of the first opening. The first cooler is fixed to the electric component box with each heat radiating fin protruding out of the electric component box through the first opening and with the main body closing the first opening.

This configuration enables satisfactory heat exchange between the first heat radiating fins and air flowing from the fan, and also enables reliable shielding of the heat pipe from the air flow. As a result, this configuration further suppresses deformation, damage, deterioration, corrosion, and alteration of the heat pipe. This configuration thus further suppresses decrease in weather resistance of the heat pipe.

According to a second aspect, the main body includes a first part and a second part. The first part is interposed between the heat pipe and the first heat radiating fins. The first part thermally connects the heat pipe to the first heat radiating fins. The second part is interposed between the first heat generating component and the heat pipe. The second part thermally connects the first heat generating component to the heat pipe.

This configuration enables shielding of the heat pipe from the blowing space, and suppresses direct contact of the heat pipe with the first heat generating component. In other words, the heat pipe is shielded by the main body in an installed state. This configuration further suppresses deformation, damage, deterioration, corrosion, and the like of the heat pipe, and facilitates improvement in weather resistance of the heat pipe. According to a third aspect, the first part may further be integrated with the second part.

According to a fourth aspect of the present invention, in the outdoor unit according to any of the first to third aspects, the heat pipe is disposed with its longitudinal axis extending horizontally.

This configuration suppresses a situation in which the coolant frozen in the heat pipe bursts the heat pipe (frost bursting). Specifically, the configuration in that the heat pipe is disposed in the horizontal direction suppresses freezing of the coolant even under an environment of low outside temperature. This configuration therefore suppresses decrease in reliability because of frost bursting in cooling the electric components using the heat pipe.

The state in which "the longitudinal axis extends horizontally" used herein involves not only a case where the longitudinal axis of the heat pipe exactly extends in the horizontal direction, but also a case where the longitudinal axis of the heat pipe is tilted relative to the horizontal direction within a predetermined angular range (e.g., 30 degrees).

According to a fifth aspect of the present invention, in the outdoor unit according to any of the first to fourth aspects, the first heat generating component includes a power device or a power module. The power module includes the power device.

The outdoor unit according to the fifth aspect of the present invention ensures a satisfactory cooling value of the first heat generating component having a larger heating value, and suppresses decrease in weather resistance of the heat pipe.

The "power device" used herein refers to, for example, a semiconductor element for power control, such as an insulated gate bipolar transistor (IGBT) in an inverter. The "power module" used herein refers to, for example, an intelligent power module (IPM) including a power device.

According to a sixth aspect of the present invention, the outdoor unit according to the fifth aspect further includes a second heat generating component, a second board, and a second cooler. The second heat generating component is configured to control a driven state of the fan. The second heat generating component is mounted on the second board. The second cooler is thermally connected to the second heat generating component. The second cooler is configured to cool the second heat generating component. The second cooler includes a plurality of second heat radiating fins. The second heat radiating fins are configured to exchange heat with the air flow.

In the outdoor unit according to the sixth aspect of the present invention, the first heat generating component having a larger heating value is cooled by the heat pipe. This configuration ensures a cooling value. On the other hand, the second heat generating component smaller in heating value than the first heat generating component is cooled by the first heat radiating fins. This configuration suppresses decrease in reliability, and reduces cost. In other words, only a heat generating component, which is unsatisfactorily cooled by only the first heat radiating fins, is cooled by the heat pipe, and another heat generating component is cooled by the first heat radiating fins. This configuration suppresses unnecessary increase in number of heat pipes, which leads to cost cutting.

The "second heat generating component" used herein is supposed to be an electric component that is smaller in heating value than the first heat generating component, and examples thereof include heat generating components such as a capacitor and a semiconductor element.

The state "thermally connected" used herein is not limited to a case where the "second cooler" and the "second heat generating component" are in direct contact with each other as long as the "second cooler" and the "second heat generating component" are disposed in a heatexchangeable state. For example, the state "thermally connected" involves a case where the "second cooler" and the "second heat generating component" are disposed with a heat-transmissive object interposed therebetween, and a case where the "second cooler" and the "second heat generating component" are disposed with a clearance formed therebetween.

According to a seventh aspect of the present invention, in the outdoor unit according to the sixth aspect, the first heat radiating fins of the first cooler are arranged with a first fin pitch. The second heat radiating fins of the second cooler are arranged with a second fin pitch. The first fin pitch is shorter than the second fin pitch.

In the outdoor unit according to the seventh aspect of the present invention, when the first fin pitch between the first heat radiating fins of the first cooler is shorter than the second fin pitch between the second heat radiating fins of the second cooler, the number of first heat radiating fins is increased. In this regard, this configuration improves heat radiating performance of the first heat radiating fins of the first cooler.

According to an eighth aspect of the present invention, in the outdoor unit according to the seventh aspect, the first heat radiating fins are lower in heightwise position than the fan and higher in heightwise position than the second heat radiating fins.

When the first fin pitch between the first heat radiating fins is shorter than the second fin pitch between the second heat radiating fins, heat exchange with the air flow is facilitated in the first cooler, which leads to improvement in cooling performance. Meanwhile, an airflow volume of air flow passing the first cooler needs to be larger than an airflow volume of air flow passing the second cooler in order that each heat radiating fin favorably exchanges heat with an air flow. Specifically, when the first heat radiating fins are arranged with a shorter first fin pitch, the number of first heat radiating fins is increased, which leads to improvement in heat radiating performance. However, the first heat radiating fins are arranged at a higher density, which may result in a situation in which an air flow is less prone to favorably pass between two of the first heat radiating fins. In view of this, in order to arrange the first heat radiating fins with a shorter first fin pitch, it is necessary to increase an airflow volume of air flow passing the first heat radiating fins in accordance with the first fin pitch such that an air flow favorably passes between two of the first heat radiating fins from the viewpoint of allowing each heat radiating fin to satisfactorily exchange heat with an air flow.

In the outdoor unit according to the eighth aspect of the present invention, the first heat radiating fins of the first cooler are arranged with a first fin pitch that is shorter than that between the second heat radiating fins of the second cooler. The first heat radiating fins are lower in heightwise position than the fan and higher in heightwise position than the second heat radiating fins (i.e., closer to the fan than the second heat radiating fins are). This configuration makes an airflow volume of air flow passing the first heat radiating fins of the first cooler higher than an airflow volume of air flow passing the second heat radiating fins. This configuration thus facilitates improvement in cooling performance of the first cooler.

According to a ninth aspect of the present invention, in the outdoor unit according to any of the first to eighth aspects, the electric component box has in its top face an exhaust port. Air is discharged through the exhaust port. The exhaust port is lower in heightwise position than the fan and higher in heightwise position than the first heat radiating fins.

In the outdoor unit according to the ninth aspect of the present invention, the exhaust port in the electric component box is lower in heightwise position than the fan and higher in heightwise position than the first heat radiating fins. In other words, the exhaust port in the electric component box is on the leeward side of the air flow with respect to the first heat radiating fins. This configuration suppresses a situation in which the air flow for heat exchange with the first heat radiating fins are heated by air to be discharged through the exhaust port in the electric component box. This configuration thus suppresses a situation in which the air discharged from the electric component box causes a small temperature difference between the first heat radiating fins and the air flow, and suppresses reduction in cooling value of the first heat generating component.

According to a tenth aspect of the present invention, in the outdoor unit according to the ninth aspect, the electric component box includes a cover part spaced apart from the exhaust port and located on an upper side of the electric component box. The cover part is configured to suppress entry of liquid into the exhaust port.

This configuration therefore reliably suppresses the entry of liquid into the electric component box through the exhaust port, and improves reliability for a short circuit, corrosion, and the like as to each electric component.

### <Advantageous Effects of the Invention>

In the outdoor unit according to the first aspect of the present invention, the heat pipe is shielded from the space (e.g., the blowing space) outside the electric component box. As a result, this configuration suppresses a situation in which the heat pipe undergoes deformation, damage, and electrolytic corrosion because of contact with another device, and also undergoes deterioration, corrosion, and alteration because of direct exposure to an air flow. This configuration thus suppresses decrease in cooling performance of the heat pipe because of decrease in weather resistance. This configuration therefore suppresses decrease in reliability.

The outdoor unit according to the second aspect of the present invention further suppresses decrease in weather resistance of the heat pipe.

The outdoor unit according to the third aspect of the present invention facilitates improvement in weather resistance of the heat pipe.

The outdoor unit according to the fourth aspect of the present invention suppresses decrease in reliability because of frost bursting in cooling the electric components using the heat pipe.

The outdoor unit according to the fifth aspect of the present invention ensures a satisfactory cooling value of the first heat generating component having a larger heating value, and suppresses decrease in weather resistance of the heat pipe.

The outdoor unit according to the sixth aspect of the present invention achieves cost cutting.

The outdoor unit according to the seventh aspect of the present invention improves heat radiating performance of the first heat radiating fins of the first cooler.

The outdoor unit according to the eighth aspect of the present invention facilitates improvement in cooling performance of the first cooler.

The outdoor unit according to the ninth aspect of the present invention suppresses reduction in cooling value of the first heat generating component.

The outdoor unit according to the tenth aspect of the present invention improves reliability for a short circuit, corrosion, and the like as to each electric component.

### BRIEF DESCRIPTION OF THE DRAWINGS

FIG. 1 is a schematic configuration diagram of an air conditioning system including an outdoor unit according to an embodiment of the present invention.
FIG. 2 is a front perspective view of the outdoor unit.
FIG. 3 is a rear perspective view of the outdoor unit.
FIG. 4 is a schematic exploded view of the outdoor unit.
FIG. 5 is a perspective view of an exemplary outdoor unit including two fan modules.
FIG. 6 is a schematic view of a layout of devices on a bottom frame and direction of an outdoor air flow.
FIG. 7 is a front enlarged view of the outdoor unit from which a first front face panel is detached.
FIG. 8 is a schematic view of an outdoor air flow in an outdoor unit casing.
FIG. 9 is a front view of an electric component box from which a front face cover is detached.
FIG. 10 is a rear view of the electric component box illustrated in FIG. 9.
FIG. 11 is a right side view of the electric component box illustrated in FIG. 9.
FIG. 12 is a front view of the electric component box from which a vertical plate (a control board) is detached.
FIG. 13 is a front perspective view of the electric component box illustrated in FIG. 12.
FIG. 14 is a front perspective view of a main body frame.
FIG. 15 is a front perspective view of the main body frame seen from an angle different from that in FIG. 14.
FIG. 16 is a top view of the electric component box from which a top face cover is detached.
FIG. 17 is a perspective view of the top face cover.
FIG. 18 is a perspective view of the top face cover seen from an angle different from that in FIG. 17.
FIG. 19 is a perspective view of a first side face cover.
FIG. 20 is a perspective view of the first side face cover seen from an angle different from that in FIG. 19.
FIG. 21 is a perspective view of a first cooling unit.
FIG. 22 is an enlarged view of segment A in FIG. 21.
FIG. 23 is a perspective view of a second cooling unit.
FIG. 24 is an enlarged view of segment B in FIG. 23.
FIG. 25 is a schematic view about how a compressor control board, a fan control board, the first cooling unit, and the second cooling unit are fixed to the main body frame.
FIG. 26 is a front perspective view of a high-heat generating electric component (a power module) fixed to the first cooling unit.
FIG. 27 is a front view of the first cooling unit fixed to the main body frame.
FIG. 28 is a rear perspective view of the first cooling unit and the second cooling unit in an installed state.
FIG. 29 is a schematic view of a relationship between positions of the compressor control board (high-heat generating electric component), first cooling unit (first cooling unit fin), fan control board (fan controlling electric component), and second cooling unit (second cooling unit fin) and an air flow path of an outdoor air flow.

### DESCRIPTION OF EMBODIMENTS

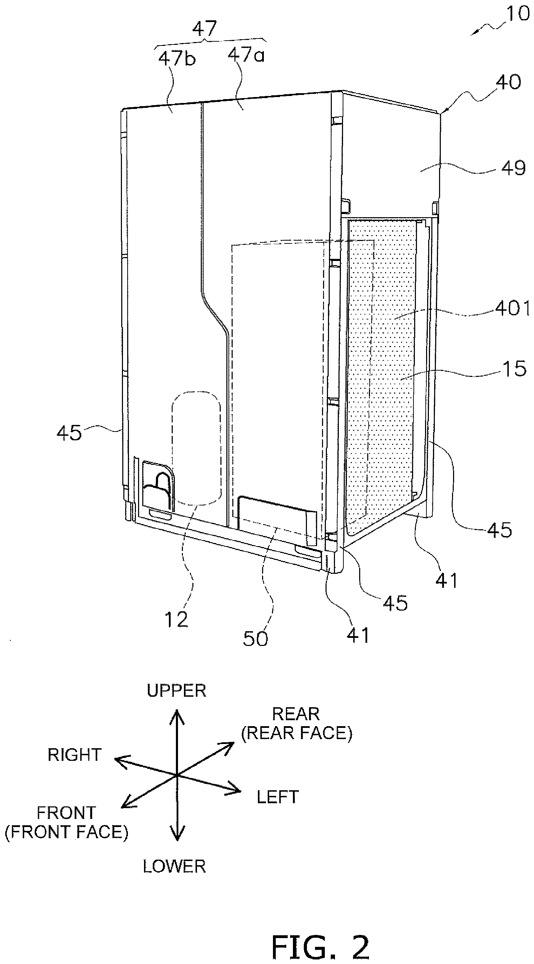

An outdoor unit 10 according to an embodiment of the present invention will be described below with reference to the drawings. It should be noted that the following embodiment is merely a specific example of the present invention, does not intend to limit the technical scope of the present invention, and may be appropriately modified without departing from the scope of the present invention which is solely defined in the appended claims. In the following description, the terms "upper", "lower", "left", "right", "front", "rear", "front face", and "rear face" denote directions illustrated in FIGS. 2 to 29, unless otherwise specified (provided that the left side and the right side and/or the front side and the rear side may be turned appropriately in the following embodiment).

The outdoor unit 10 according to the embodiment of the present invention is applied to an air conditioning system 100 (a refrigeration apparatus).

### (1) Air Conditioning System 100

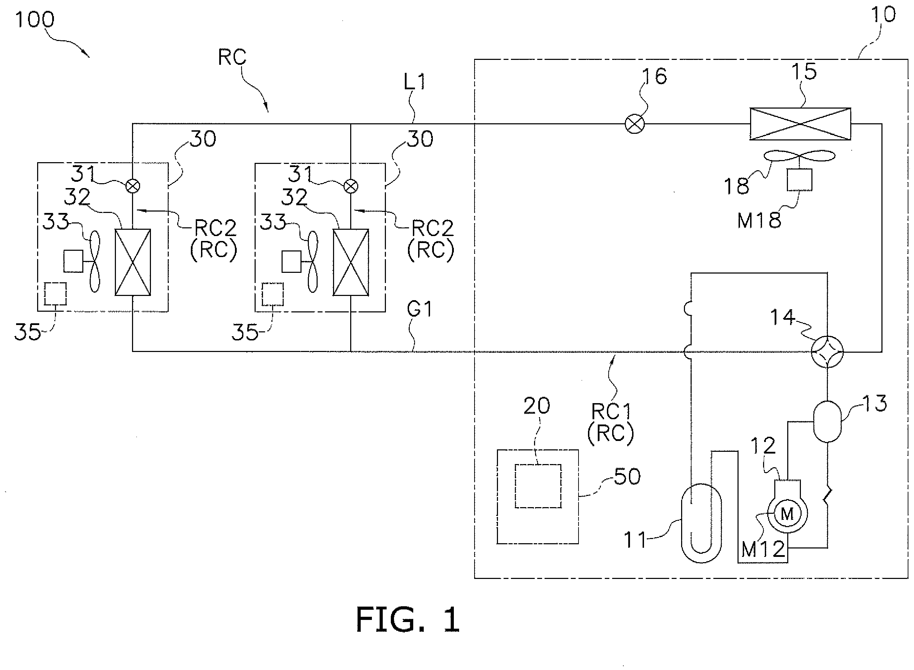

FIG. 1 is a schematic configuration diagram of the air conditioning system 100 including the outdoor unit 10 according to the embodiment of the present invention. The air conditioning system 100 is configured to perform air conditioning, such as cooling or heating, on a target space (a residential space, a space to be subjected to air conditioning in, for example, a store house) by a vapor compression refrigeration cycle. The air conditioning system 100 mainly includes the outdoor unit 10, a plurality of (two in this embodiment) indoor units 30 (30a, 30b), a liquid-side connection pipe L1, and a gas-side connection pipe G1.

In the air conditioning system 100, the outdoor unit 10 and the indoor units 30 are connected via the liquid-side connection pipe L1 and the gas-side connection pipe G1 to constitute a refrigerant circuit RC. The air conditioning system 100 performs a refrigeration cycle to compress, cool or condense, decompress, heat or evaporate, and then compress again a refrigerant in the refrigerant circuit RC.

### (1-1) Outdoor Unit 10

The outdoor unit 10 is installed in outdoor space. The outdoor space refers to space other than a target space to be subjected to air conditioning, and examples thereof include the outside such as the roof of a building, and underground space. The outdoor unit 10 is connected to the indoor units 30 via the liquid-side connection pipe L1 and the gas-side connection pipe G1 to constitute a part (an outdoor-side circuit RC1) of the refrigerant circuit RC. The outdoor unit 10 mainly includes an accumulator 11, a compressor 12, an oil separator 13, a four-way switching valve 14, an outdoor heat exchanger 15, an outdoor expansion valve 16, and the like as devices that constitute the outdoor-side circuit RC1. These devices (11 to 16) are connected to one another via refrigerant pipes.

The accumulator 11 is a container configured to store the refrigerant and to separate the gas refrigerant from the liquid refrigerant, so as to suppress excessive suction of the liquid refrigerant into the compressor 12.

The compressor 12 is a device configured to change by compression the low-pressure refrigerant to the high-pressure refrigerant in the refrigeration cycle. The compressor 12 used in this embodiment is a closed compressor in which a displacement, such as rotary or scroll, compression element is driven to rotate by a compressor motor M12. The compressor motor M12 has an operating frequency controllable by an inverter, and controlling the operating frequency enables capacity control for the compressor 12. The start, stop, and operating capacity of the compressor 12 are controlled by an outdoor unit control unit 20.

The oil separator 13 is a container configured to separate a refrigerating machine oil compatible with the refrigerant discharged from the compressor 12 and to return the refrigerating machine oil to the compressor 12.

The four-way switching valve 14 is a flow path switching valve for switching a flow of the refrigerant in the refrigerant circuit RC.

The outdoor heat exchanger 15 is a heat exchanger that functions as a condenser (or a radiator) or an evaporator for the refrigerant.

The outdoor expansion valve 16 is an electric valve whose opening degree is controllable. The outdoor expansion valve 16 decompresses the incoming refrigerant or adjusts the flow rate of the incoming refrigerant, in accordance with the opening degree.

The outdoor unit 10 also includes an outdoor fan 18 (which is an example of a "fan" in the claims) configured to provide an outdoor air flow AF. The outdoor air flow AF (which is an example of an "air flow" in the claims) is a flow of air flowing into the outdoor unit 10 from the outside of the outdoor unit 10 and passing through the outdoor heat exchanger 15. The outdoor air flow AF serves as a cooling source or a heating source for the refrigerant flowing through the outdoor heat exchanger 15. The outdoor air flow AF passing through the outdoor heat exchanger 15 exchanges heat with the refrigerant in the outdoor heat exchanger 15. The outdoor fan 18 includes an outdoor fan motor M18, and is driven in conjunction with the outdoor fan motor M18. The start and stop of the outdoor fan 18 are appropriately controlled by the outdoor unit control unit 20. In this embodiment, the outdoor fan 18 (the outdoor fan motor M18) is not subjected to inverter control.

The outdoor unit 10 also includes a plurality of outdoor-side sensors (not illustrated) each configured to detect a state (mainly, a pressure, a temperature) of the refrigerant in the refrigerant circuit RC. Each of the outdoor-side sensors is a pressure sensor or a temperature sensor such as a thermistor or a thermocouple. The outdoor-side sensors include, for example, a suction pressure sensor configured to detect a suction pressure that is a pressure of the refrigerant at the suction side of the compressor 12, a discharge pressure sensor configured to detect a discharge pressure that is a pressure of the refrigerant at the discharge side of the compressor 12, and a temperature sensor configured to detect a temperature of the refrigerant in the outdoor heat exchanger 15.

The outdoor unit 10 also includes the outdoor unit control unit 20 configured to control operations and states of the devices in the outdoor unit 10. The outdoor unit control unit 20 includes: a microcomputer including a central processing unit (CPU), a memory, and the like, and various electric components (e.g., a capacitor, a semiconductor element, a coil component). The outdoor unit control unit 20 is electrically connected to the devices (e.g., 12, 14, 16, 18) and outdoor-side sensors in the outdoor unit 10 to exchange signals with the devices and outdoor-side sensors. The outdoor unit control unit 20 also exchanges, for example, control signals with indoor unit control units 35 of the respective indoor units 30 and remote controllers (not illustrated). The outdoor unit control unit 20 is housed in an electric component box 50 to be described later.

A specific description on the structure of the outdoor unit 10 will be given later.

### (1-2) Indoor Units 30

Each indoor unit 30 is installed in the interior (e.g., a residential room, a roof-space), and constitutes a part (an indoor-side circuit RC2) of the refrigerant circuit RC. Each indoor unit 30 mainly includes an indoor expansion valve 31, an indoor heat exchanger 32, and the like as devices that constitute the indoor-side circuit RC2.

The indoor expansion valve 31 is an electric valve whose opening degree is controllable. The indoor expansion valve 31 decompresses the incoming refrigerant or adjusts the flow rate of the incoming refrigerant, in accordance with the opening degree.

The indoor heat exchanger 32 is a heat exchanger that functions as an evaporator or a condenser (or a radiator) for the refrigerant.

Each indoor unit 30 also includes an indoor fan 33 for sucking air inside a target space, allowing the air to pass through the indoor heat exchanger 32, causing the air to exchange heat with the refrigerant in the indoor heat exchanger 32, and then supplying the air to the target space again. The indoor fan 33 includes an indoor fan motor serving as a drive source. The indoor fan 33 is driven to provide an indoor air flow. The indoor air flow is a flow of air that flows into each indoor unit 30 from the target space, passes through the indoor heat exchanger 32, and then is blown out of the indoor unit 30 toward the target space. The indoor air flow serves as a heating source or a cooling source for the refrigerant flowing through the indoor heat exchanger 32. The indoor air flow passing through the indoor heat exchanger 32 exchanges heat with the refrigerant in the indoor heat exchanger 32.

Each indoor unit 30 also includes the indoor unit control unit 35 configured to control operations and states of the devices (e.g., 35) in the indoor unit 30. The indoor unit control unit 35 includes: a microcomputer including a CPU, a memory, and the like; and various electric components.

### (1-3) Liquid-side Connection Pipe L1, Gas-side Connection Pipe G1

Each of the liquid-side connection pipe L1 and the gas-side connection pipe G1 is a connection pipe for connecting the outdoor unit 10 to each of the indoor units 30, and is constructed on site. The pipe lengths and pipe diameters of the liquid-side connection pipe L1 and gas-side connection pipe G1 are appropriately selected in accordance with design specifications and installation environments.

### (2) Flow of Refrigerant in Refrigerant Circuit RC

Next, a description will be given of the flow of the refrigerant in the refrigerant circuit RC. The air conditioning system 100 mainly performs a forward cycle operation and a reverse cycle operation. The low pressure in the refrigeration cycle is a pressure (a suction pressure) of the refrigerant sucked into the compressor 12, and the high pressure in the refrigeration cycle is a pressure (a discharge pressure) of the refrigerant discharged from the compressor 12.

### (2-1) Flow of Refrigerant during Forward Cycle Operation

During the forward cycle operation (e.g., a cooling operation), the four-way switching valve 14 is in a forward cycle state (a state indicated by a solid line in the four-way switching valve 14 illustrated in FIG. 1). When the forward cycle operation is started, the refrigerant is sucked into and compressed by the compressor 12, and then is discharged from the compressor 12, in the outdoor-side circuit RC1. The compressor 12 is subjected to capacity control according to a heating load to be required for an indoor unit 30 under operation. Specifically, an operating frequency of the compressor 12 is controlled such that the suction pressure takes a target value set in accordance with the heating load to be required for the indoor unit 30. The gas refrigerant discharged from the compressor 12 flows into the outdoor heat exchanger 15.

When the gas refrigerant flows into the outdoor heat exchanger 15, the outdoor heat exchanger 15 causes the gas refrigerant to radiate heat by heat exchange with an outdoor air flow AF supplied by the outdoor fan 18, and then condenses the gas refrigerant. When the refrigerant flows out of the outdoor heat exchanger 15, then the refrigerant passes through the outdoor expansion valve 16. The outdoor expansion valve 16 decompresses the refrigerant or adjusts the flow rate of the refrigerant, in accordance with the opening degree. The refrigerant then flows out of the outdoor-side circuit RC1. When the refrigerant flows out of the outdoor-side circuit RC1, then the refrigerant flows into the indoor-side circuit RC2 of the indoor unit 30 under operation, via the liquid-side connection pipe L1.

When the refrigerant flows into the indoor-side circuit RC2 of the indoor unit 30 under operation, then the refrigerant flows into the indoor expansion valve 31. The indoor expansion valve 31 decompresses the refrigerant to the low pressure in the refrigeration cycle, in accordance with the opening degree. The refrigerant then flows into the indoor heat exchanger 32. When the refrigerant flows into the indoor heat exchanger 32, the indoor heat exchanger 32 evaporates the refrigerant by heat exchange with an indoor air flow supplied by the indoor fan 33, thereby turning the refrigerant into the gas refrigerant. The gas refrigerant then flows out of the indoor heat exchanger 32. When the gas refrigerant flows out of the indoor heat exchanger 32, the gas refrigerant then flows out of the indoor-side circuit RC2.

When the refrigerant flows out of the indoor-side circuit RC2, then the refrigerant flows into the outdoor-side circuit RC1 via the gas-side connection pipe G1. When the refrigerant flows into the outdoor-side circuit RC1, then the refrigerant flows into the accumulator 11. When the refrigerant flows into the accumulator 11, then the refrigerant is temporarily stored in the accumulator 11. Thereafter, the refrigerant is sucked into the compressor 12 again.

### (2-2) Flow of Refrigerant during Reverse Cycle Operation

During the reverse cycle operation (e.g., a heating operation), the four-way switching valve 14 is in a reverse cycle state (a state indicated by a broken line in the four-way switching valve 14 illustrated in FIG. 1). When the reverse cycle operation is started, the refrigerant is sucked into and compressed by the compressor 12, and then is discharged from the compressor 12, in the outdoor-side circuit RC1. As in the forward cycle operation, the compressor 12 is subjected to capacity control according to a heating load to be required for an indoor unit 30 under operation. When the gas refrigerant is discharged from the compressor 12, then the gas refrigerant flows out of the outdoor-side circuit RC1. The gas refrigerant then flows into the indoor-side circuit RC2 of the indoor unit 30 under operation, via the gas-side connection pipe G1.

When the refrigerant flows into the indoor-side circuit RC2, then the refrigerant flows into the indoor heat exchanger 32. The indoor heat exchanger 32 condenses the refrigerant by heat exchange with an indoor air flow supplied by the indoor fan 33. When the refrigerant flows out of the indoor heat exchanger 32, then the refrigerant flows into the indoor expansion valve 31. The indoor expansion valve 31 decompresses the refrigerant to the low pressure in the refrigeration cycle, in accordance with the opening degree. The refrigerant then flows out of the indoor-side circuit RC2.

When the refrigerant flows out of the indoor-side circuit RC2, then the refrigerant flows into the outdoor-side circuit RC1 via the liquid-side connection pipe L1. When the refrigerant flows into the outdoor-side circuit RC1, then the refrigerant flows into the outdoor heat exchanger 15 through a liquid-side port of the outdoor heat exchanger 15.

When the refrigerant flows into the outdoor heat exchanger 15, the outdoor heat exchanger 15 evaporates the refrigerant by heat exchange with an outdoor air flow AF supplied by the outdoor fan 18. When the refrigerant flows out of the outdoor heat exchanger 15 through a gas-side port of the outdoor heat exchanger 15, then the refrigerant flows into the accumulator 11. When the refrigerant flows into the accumulator 11, then the refrigerant is temporarily stored in the accumulator 11. Thereafter, the refrigerant is sucked into the compressor 12 again.

### (3) Details of Outdoor Unit 10

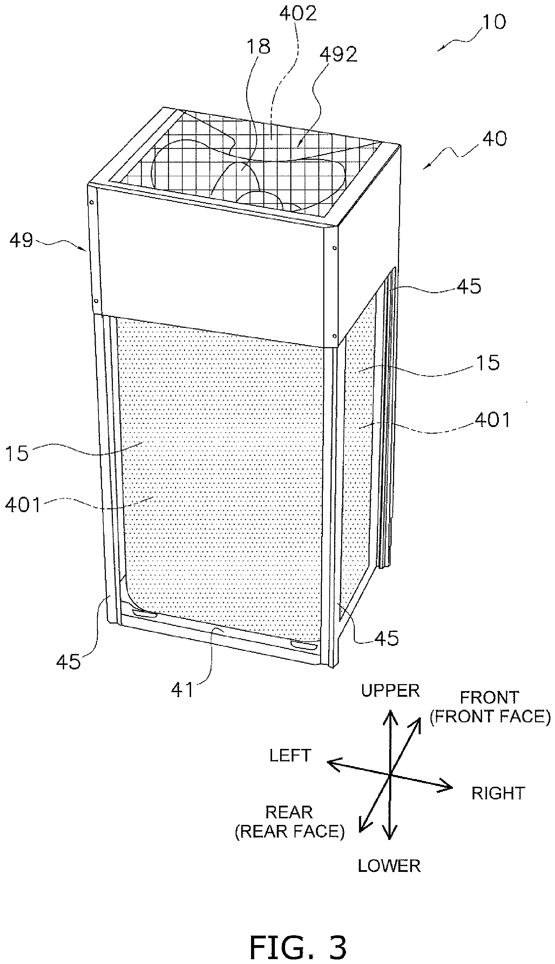

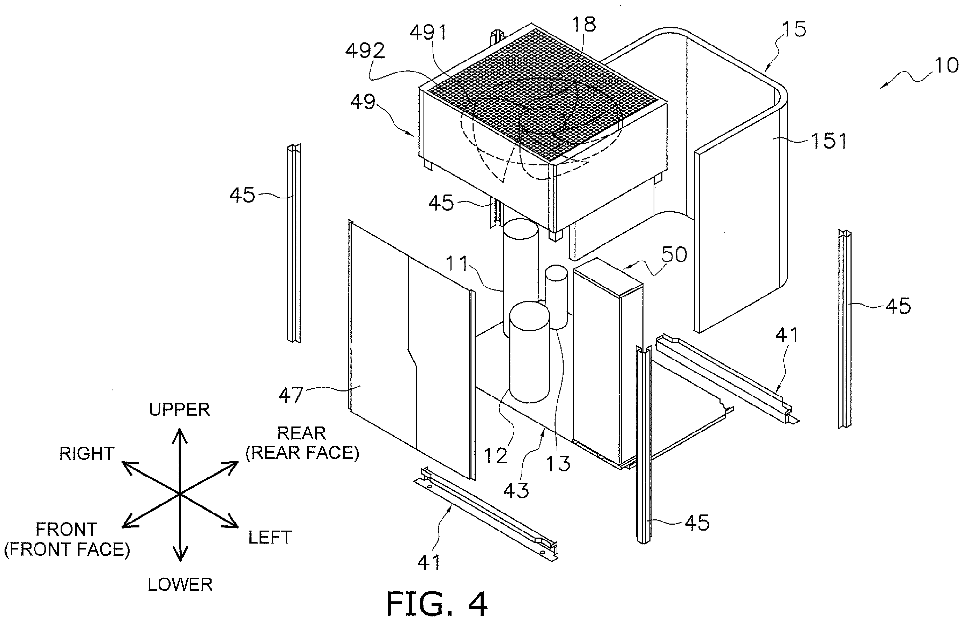

FIG. 2 is a front perspective view of the outdoor unit 10. FIG. 3 is a rear perspective view of the outdoor unit 10. FIG. 4 is a schematic exploded view of the outdoor unit 10.

### (3-1) Outdoor Unit Casing 40

The outdoor unit 10 includes an outdoor unit casing 40 constituting an outer contour and housing therein the devices (e.g., 11, 12, 13, 14, 15, 16, 20). The outdoor unit casing 40 (which is an example of a "casing" in the claims) has substantially a parallelepiped shape, and includes an assembly of sheet metal members. The outdoor unit casing 40 has openings formed in its left side face, right side face, and rear face so as to mostly occupy the left side face, right side face, and rear face. These openings function as intake ports 401 through which an outdoor air flow AF are sucked.

The outdoor unit casing 40 mainly includes a pair of installation legs 41, a bottom frame 43, a plurality of (four in this embodiment) supports 45, a front face panel 47, and a fan module 49.

Each of the installation legs 41 is a sheet metal member extending in the left-right direction and supporting the bottom frame 43 from below. The installation legs 41 are respectively located near a front end and a rear end of the outdoor unit casing 40.

The bottom frame 43 is a sheet metal member constituting a bottom face portion of the outdoor unit casing 40. The bottom frame 43 is disposed on the pair of installation legs 41. The bottom frame 43 has substantially a rectangular shape in plan view.

The supports 45 extend vertically from corner portions of the bottom frame 43, respectively. As illustrated in FIGS. 2 to 4, the supports 45 extend vertically from the four corner portions of the bottom frame 43, respectively.

The front face panel 47 is a sheet metal member constituting a front face portion of the outdoor unit casing 40. More specifically, the front face panel 47 includes a first front face panel 47a and a second front face panel 47b. The first front face panel 47a constitutes a left side of the front face portion of the outdoor unit casing 40. The second front face panel 47b constitutes a right side of the front face portion of the outdoor unit casing 40. The first front face panel 47a and the second front face panel 47b are positioned with respect to the outdoor unit casing 40. The first front face panel 47a and the second front face panel 47b are then fastened to the supports 45 with screws. The first front face panel 47a and the second front face panel 47b are thus secured to the supports 45 independently of each other.

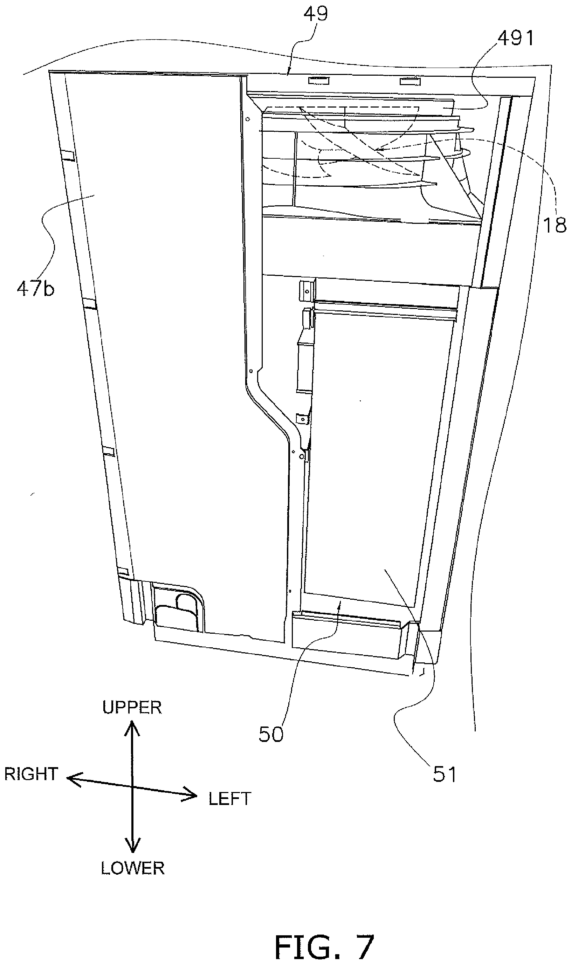

The fan module 49 is mounted to the supports 45 at a position near upper ends of the supports 45. The fan module 49 constitutes portions of a front face, the rear face, the left side face, and the right side face of the outdoor unit casing 40, the portions being located above the supports 45, and a top face of the outdoor unit casing 40. The fan module 49 includes the outdoor fan 18 and a bell mouth 491 (see FIG. 7). More specifically, the fan module 49 is an aggregate of the outdoor fan 18 and bell mouth 491 housed in substantially a parallelepiped box whose upper and lower faces are opened. In the fan module 49, the outdoor fan 18 is disposed such that its axis extends vertically. The fan module 49 has an opened upper face portion that functions as a blow-out port 402 through which an outdoor air flow AF is blown out of the outdoor unit casing 40. A grid-shaped grille 492 is disposed on the blow-out port 402.

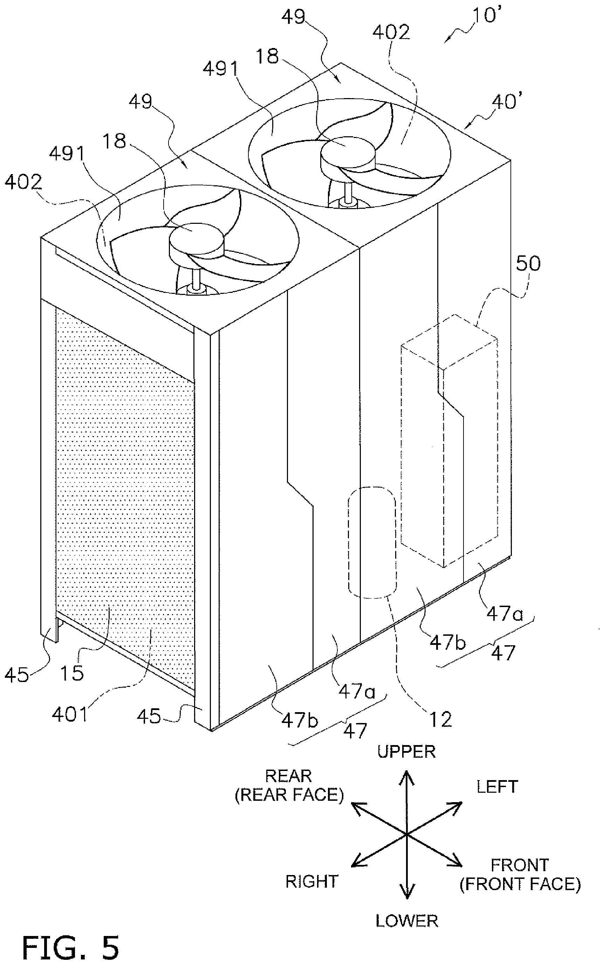

As illustrated in FIGS. 2 to 4, the outdoor unit 10 includes one fan module 49. Alternatively, the outdoor unit 10 may include a plurality of fan modules 49. As illustrated in FIG. 5, for example, an outdoor unit 10' may include two fan modules 49. In the outdoor unit 10' illustrated in FIG. 5, the two fan modules 49 are arranged side by side in the left-right direction. The outdoor unit 10' includes an outdoor unit casing 40' that is larger in dimensions than the outdoor unit casing 40 of the outdoor unit 10 including one fan module 49. The outdoor unit casing 40' includes two front face panels 47 arranged side by side in the left-right direction. Although not illustrated in the drawings, an outdoor heat exchanger 15 of the outdoor unit 10' is larger in dimensions than the outdoor heat exchanger 15 of the outdoor unit 10, in accordance with the dimensions of the outdoor unit casing 40'.

### (3-2) Layout of Devices on Bottom Frame 43

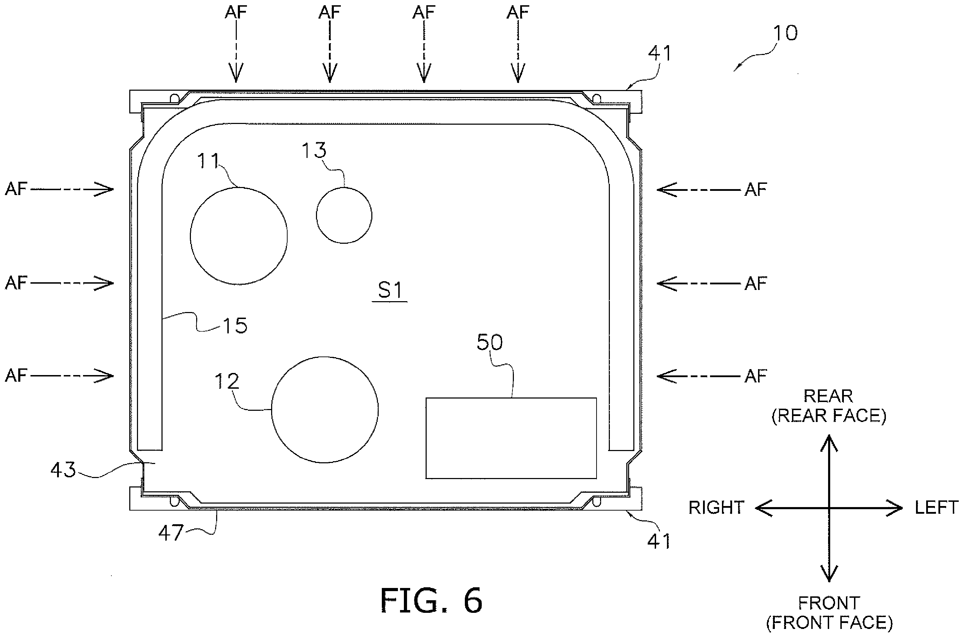

FIG. 6 is a schematic view of a layout of the devices on the bottom frame 43 and direction of an outdoor air flow AF. As illustrated in FIG. 6, various devices, including the accumulator 11, the compressor 12, the oil separator 13, and the outdoor heat exchanger 15, are disposed at predetermined positions on the bottom frame 43. In addition, the electric component box 50 housing therein the outdoor unit control unit 20 is disposed on the bottom frame 43.

The outdoor heat exchanger 15 has heat exchange faces 151 (see FIG. 4) respectively extending along the left side face, right side face, and rear face of the outdoor unit casing 40. The heat exchange faces 151 are substantially equal in height to the intake ports 401. The intake ports 401 mostly occupy the rear face, left side face, and right side face of the outdoor unit casing 40. The heat exchange faces 151 of the outdoor heat exchanger 15 are respectively exposed from the intake ports 401. In other words, the rear face, left side face, and right side face of the outdoor unit casing 40 are substantially formed of the heat exchange faces 151 of the outdoor heat exchanger 15. The outdoor heat exchanger 15 has three heat exchange faces 151. In this regard, the outdoor heat exchanger 15 has left and right curved portions in plan view. In other words, the outdoor heat exchanger 15 has substantially a U shape opened toward the front face.

The accumulator 11 is disposed on a left forward side of the right curved portion of the outdoor heat exchanger 15 and a right rearward side of the compressor 12.

The compressor 12 is disposed on a left side of a right-side end of the outdoor heat exchanger 15 and a left forward side of the accumulator 11. The compressor 12 is located on the right side of the front face portion of the outdoor unit casing 40. The compressor 12 is located below the fan module 49 (the outdoor fan 18). In other words, the outdoor fan 18 is higher in heightwise position than the compressor 12.

The oil separator 13 is disposed on a left side of the accumulator 11.

As illustrated in FIGS. 2 and 4 to 6, the electric component box 50 (which is an example of an "electric component box" in the claims) is disposed on a right side of a left-side end of the outdoor heat exchanger 15 and a left side of the compressor 12. The electric component box 50 is located on the left side of the front face portion of the outdoor unit casing 40. FIG. 7 is a front enlarged view of the outdoor unit 10 from which the first front face panel 47a is detached. As illustrated in FIG. 7, the electric component box 50 is exposed from the front face of the outdoor unit 10 in the state in which the first front face panel 47a is detached from the outdoor unit 10. The electric component box 50 is thus accessible only by detaching the first front face panel 47a without detaching the second front face panel 47b. The electric component box 50 includes a front face cover 51 constituting the front face portion. A specific description on the electric component box 50 will be given later.

### (3-3) Outdoor Air Flows AF in Outdoor Unit Casing 40

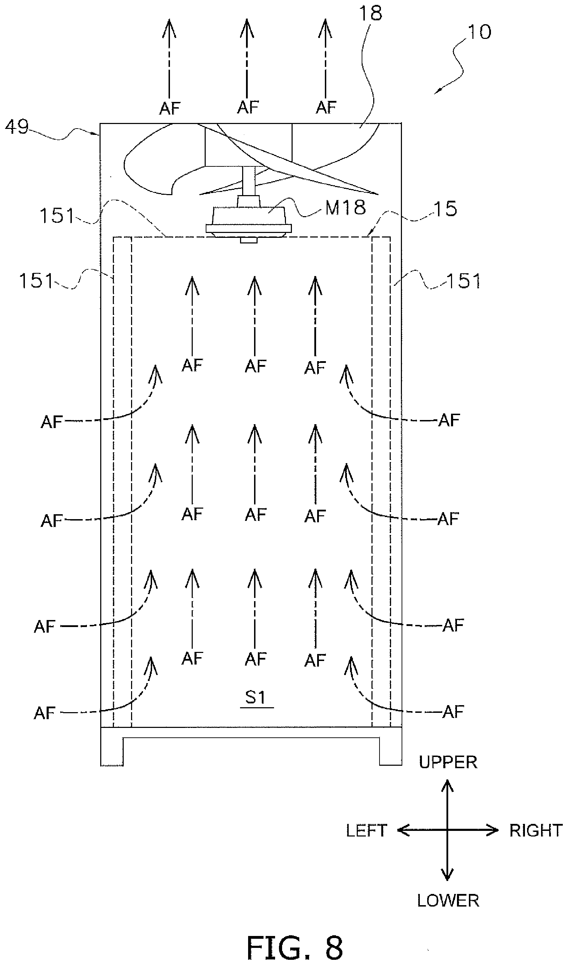

FIG. 8 is a schematic view of the outdoor air flow AF in the outdoor unit casing 40. As illustrated in FIGS. 6 and 8, the outdoor air flow AF flow into the outdoor unit casing 40 through the intake ports 401 in the left side face, right side face, and rear face of the outdoor unit casing 40, and pass through the outdoor heat exchanger 15 (the heat exchange faces 151). The outdoor air flow AF then mainly flow from below upward to flow out of the outdoor unit casing 40 through the blow-out port 402. Specifically, the outdoor air flow AF flow horizontally into the outdoor unit casing 40 through the intake ports 401, pass through the outdoor heat exchanger 15, turn upward, and flow from below upward toward the blow-out port 402.

In the following description, a space, where a main flow path of the outdoor air flow AF are formed, in the outdoor unit casing 40 (a space surrounded with the outdoor heat exchanger 15 and the front face panel 47 in FIG. 6) is referred to as a "blowing space S1".

### (4) Details of Electric Component Box 50

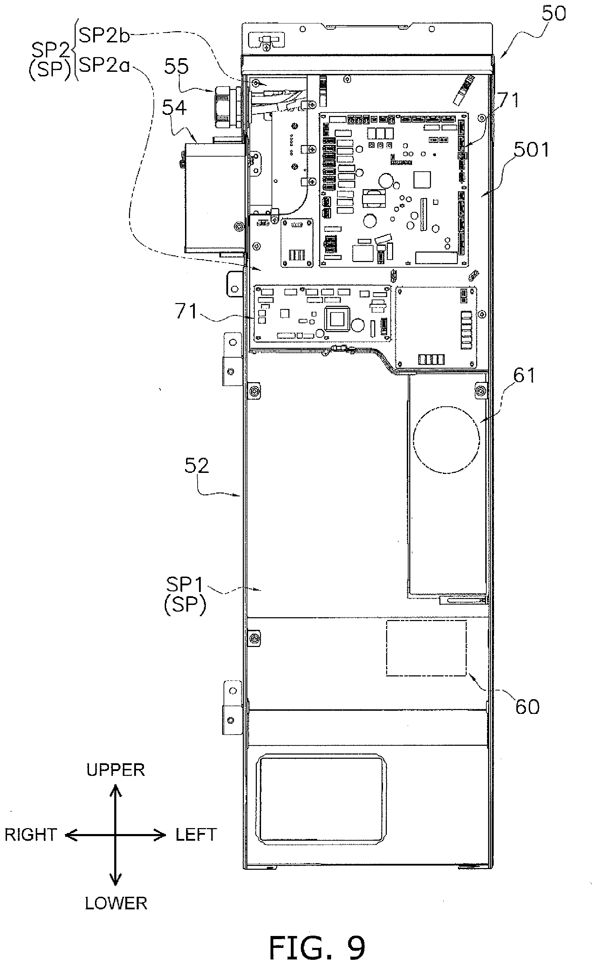

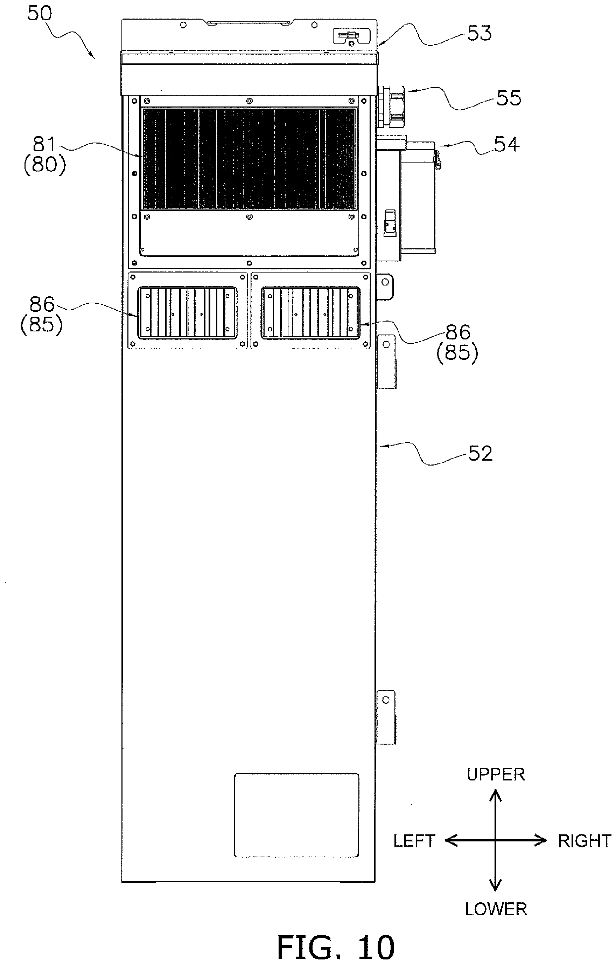

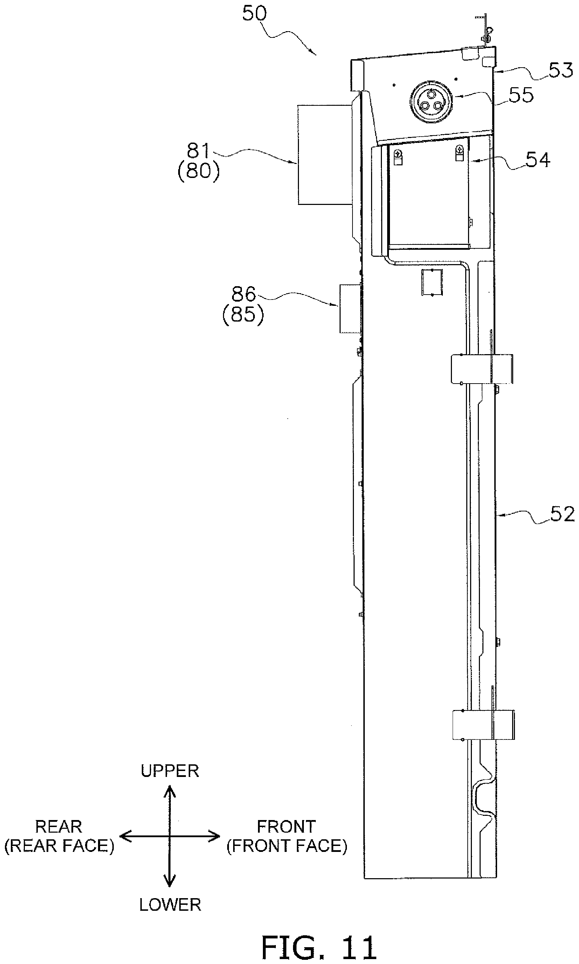

FIG. 9 is a front view of the electric component box 50 from which the front face cover 51 is detached. FIG. 10 is a rear view of the electric component box 50 illustrated in FIG. 9. FIG. 11 is a right side view of the electric component box 50 illustrated in FIG. 9.

### (4-1) Space in Electric Component Box 50 and Layout of Devices in Electric Component Box 50

The electric component box 50 is substantially a parallelepiped box which is made of metal and of which a length in the height direction (the upper-lower direction in this embodiment) is longer than a length in the width direction (the left-right direction in this embodiment) and a length in the depth direction (the front-rear direction in this embodiment). Various components constituting the outdoor unit control unit 20 are accommodated in a space defined in the electric component box 50 (hereinafter, referred to as an "inner space SP").

The inner space SP includes a lower space SP1 and an upper space SP2 located above the lower space SP1. The lower space SP1 and the upper space SP2 communicate with each other without being separated from each other, and there is no clear boundary between them.

The lower space SP1 extends from a lower end of the inner space SP (a bottom face portion of the electric component box 50) by a predetermined heightwise length (a length that is about substantially two-thirds of a heightwise length of the inner space SP). Electric components such as a terminal block 60 and a reactor 61 are disposed in the lower space SP1.

The upper space SP2 extends from an upper end of the lower space SP1 to an upper end of the inner space SP (a top face portion of the electric component box 50). A vertical plate 501 is disposed in the upper space SP2 to partition the upper space SP2 into two spaces in the depth direction (the front-rear direction). The vertical plate 501 is a metal sheet extending vertically. The vertical plate 501 partitions the upper space SP2 into a front-side upper space SP2a and a rear-side upper space SP2b located on a rear face side of the front-side upper space SP2a. The front-side upper space SP2a and the rear-side upper space SP2b are arranged in the depth direction of the electric component box 50.

A plurality of (two in this embodiment) control boards 71 are accommodated in the front-side upper space SP2a. On each control board 71, a microcomputer including a CPU, various memories, and the like and a communication module are mounted. The control boards 71 are fixed to a front face portion of the vertical plate 501. Each of the control boards 71 is fixed to the vertical plate 501 such that a main surface thereof is directed to the front face (i.e., each control board 71 is thick in the front-rear direction).

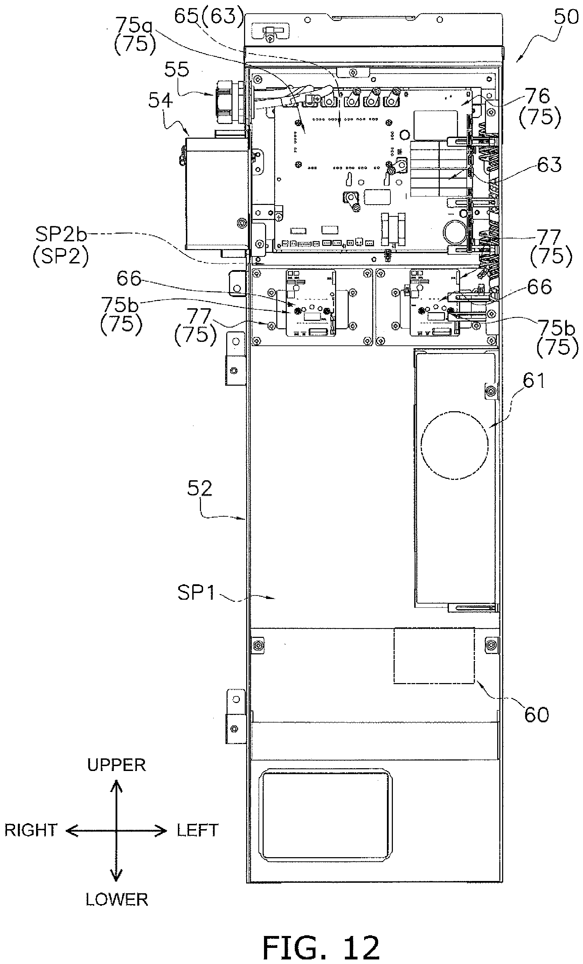

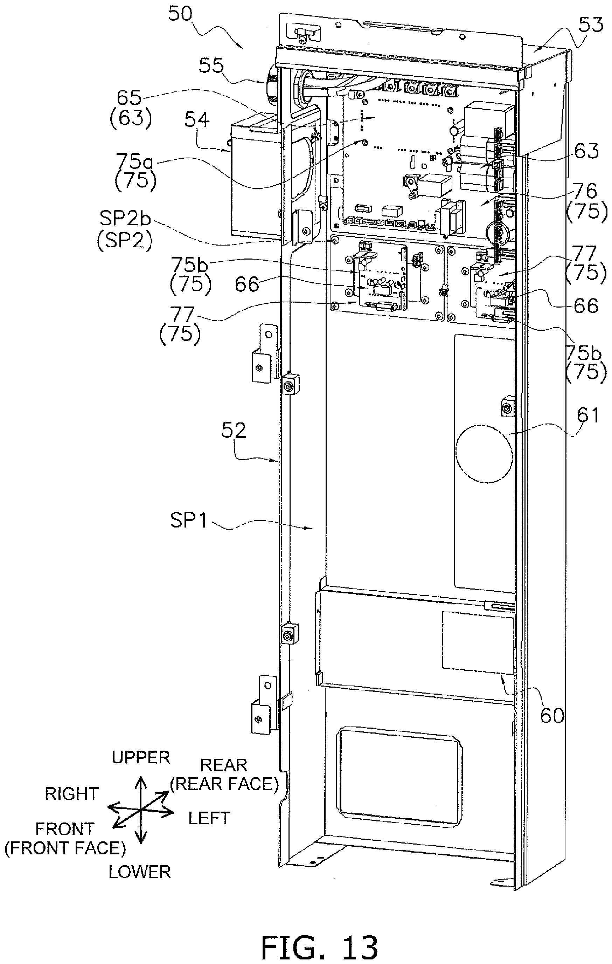

FIG. 12 is a front view of the electric component box 50 from which the vertical plate 501 (the control boards 71) is detached. FIG. 13 is a front perspective view of the electric component box 50 illustrated in FIG. 12.

Aboard unit 75 is accommodated in the rear-side upper space SP2b. On the board unit 75, various electric components are mounted for controlling driven states of the actuators disposed in the outdoor unit 10. Specifically, the board unit 75 includes: a compressor controlling electric component mount portion 75a on which electric components for invertercontrolling the compressor 12 (hereinafter, referred to as "compressor controlling electric components 63" are mounted; and fan controlling electric component mount portions 75b on which electric components for controlling driven states of the outdoor fans 18 (hereinafter, referred to as "fan controlling electric components 66") are mounted.

In this embodiment, the compressor controlling electric components 63 are mounted on a compressor control board 76 (which is an example of a "first board" in the claims) that is a part of the board unit 75. In this embodiment, in other words, the compressor controlling electric component mount portion 75a is disposed on the compressor control board 76. In addition, the fan controlling electric components 66 are mounted on fan control boards 77 (each of which is an example of a "second board" in the claims). Each of the fan control boards 77 is a part of the board unit 75. In this embodiment, in other words, the fan controlling electric component mount portions 75b are respectively disposed on the fan control boards 77.

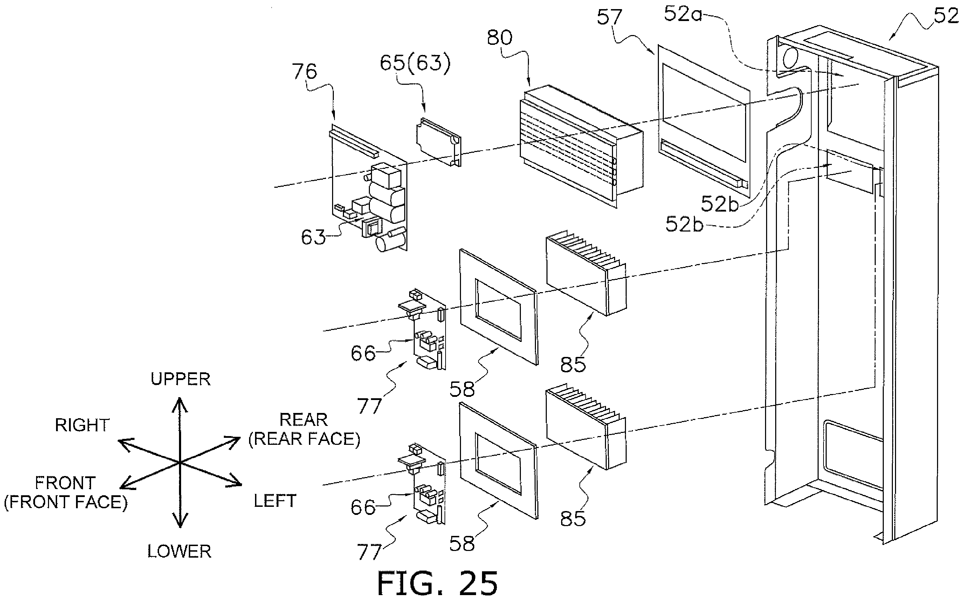

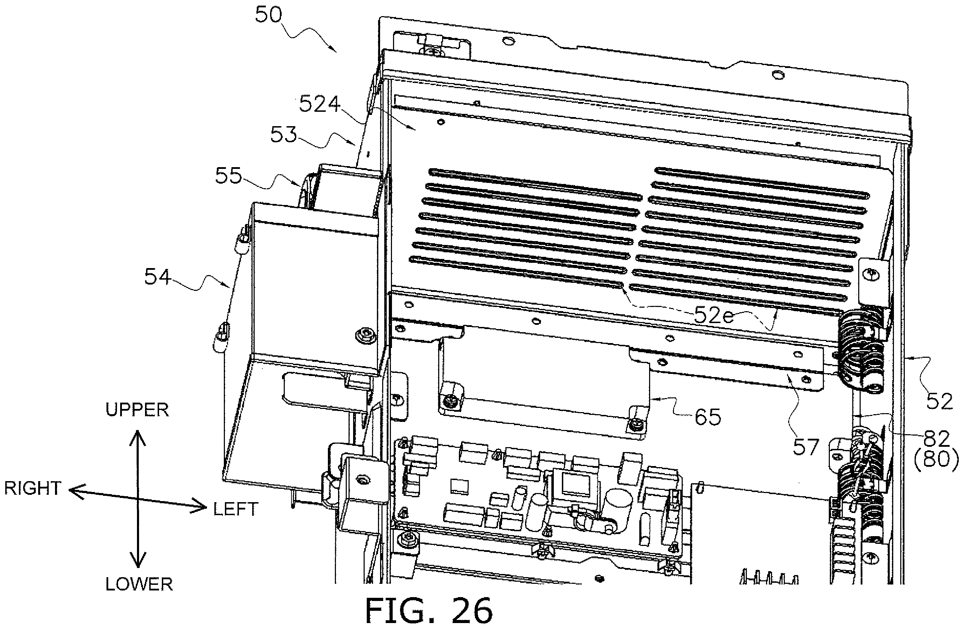

The compressor controlling electric components 63 include an electric component configured to generate heat when being energized. Examples of the compressor controlling electric components 63 include a smoothing capacitor, a diode bridge, and the like to be mounted on a front-side main surface of the compressor control board 76. The compressor controlling electric components 63 also include an electric component that is considerably larger in heating value upon energization than the other electric components (hereinafter, such an electric component is referred to as a "high-heat generating electric component 65"). Examples of the high-heat generating electric component 65 (which is an example of a "first heat generating component" in the claims) include various electric components (e.g., power devices including a switching element, such as an insulated gate bipolar transistor (IGBT)) constituting an inverter. As illustrated in FIGS. 25 and 26, more specifically, a power module including a plurality of (six in this embodiment) integrated power devices is mounted as the high-heat generating electric component 65 on the compressor control board 76 (the compressor controlling electric component mount portion 75a). The high-heat generating electric component 65 (the power module) is mounted on a rear-side main surface of the compressor control board 76. The power module is particularly larger in heating value upon energization than the other electric components. The power module is, for example, an intelligent power module (IPM) including a plurality of power devices. In the state in which the electric component box 50 is disposed in the outdoor unit casing 40, the high-heat generating electric component 65 is lower in heightwise position than the outdoor fans 18 and higher in heightwise position than the fan controlling electric components 66.

The fan controlling electric components 66 (each of which is an example of a "second heat generating component" in the claims) include an electric component configured to generate heat when being energized. Examples of the fan controlling electric components 66 include a capacitor, a diode, and a switch such as a relay. In FIGS. 12 and 13, on the assumption that the outdoor unit 10 includes two outdoor fans 18 (e.g., the outdoor unit 10' illustrated in FIG. 5), two fan control boards 77 (two fan controlling electric component mount portions 75b) are arranged side by side in the left-right direction in the rear-side upper space SP2b in one-to-one correspondence with the outdoor fans 18. The fan controlling electric components 66 are smaller in heating value upon energization than the high-heat generating electric component 65.

In the rear-side upper space SP2b, a first cooling unit 80 for cooling the compressor controlling electric components 63 (mainly, the high-heat generating electric component 65) mounted on the compressor control board 76 is disposed on a rear face side of the compressor control board 76. A specific description on the first cooling unit 80 will be given later.

Also in the rear-side upper space SP2b, second cooling units 85 are disposed for cooling the fan controlling electric components 66 mounted on the fan control boards 77. More specifically, the second cooling units 85 disposed in the rear-side upper space SP2b are equal in number (two in this embodiment) to the fan control boards 77. The second cooling units 85 are in one-to-one correspondence with the fan control boards 77. Each of the second cooling units 85 is disposed on a rear face side of the corresponding fan control board 77. A specific description on the second cooling units 85 will be given later.

### (4-2) Configuration of Electric Component Box 50

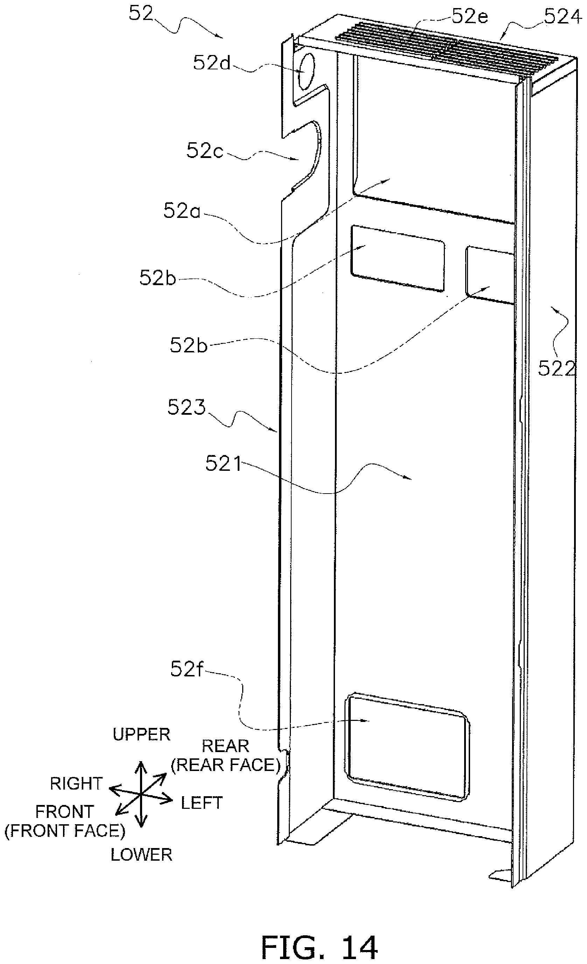

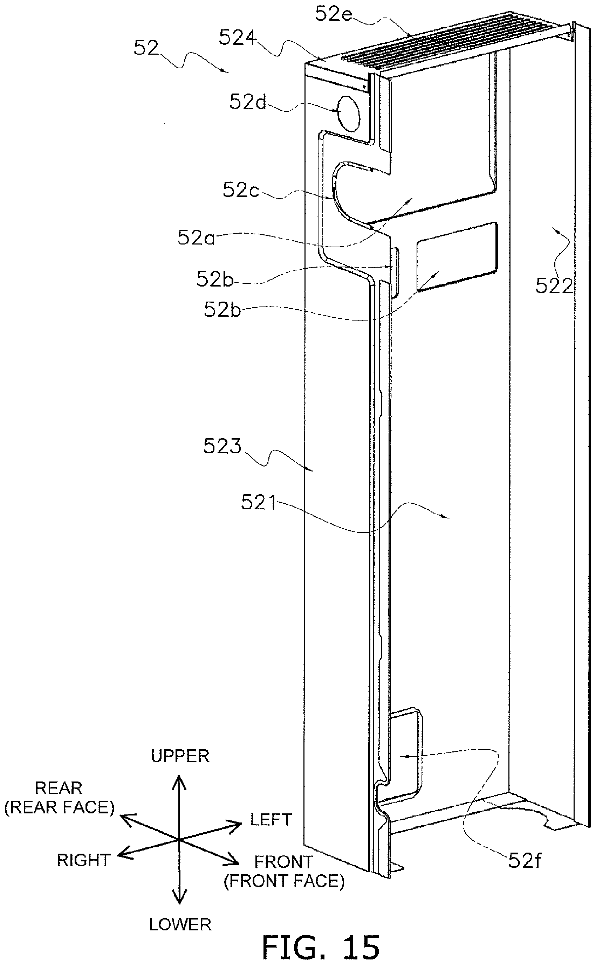

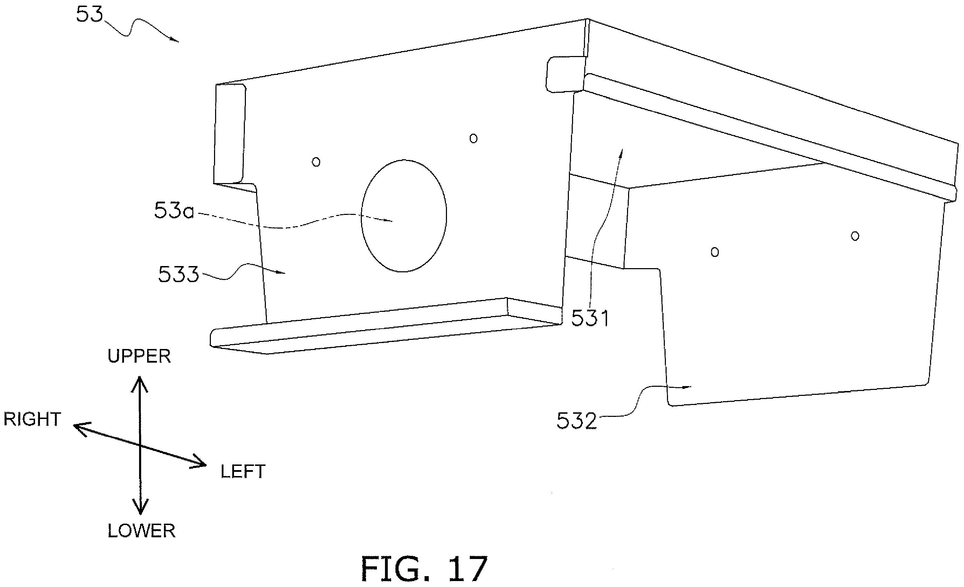

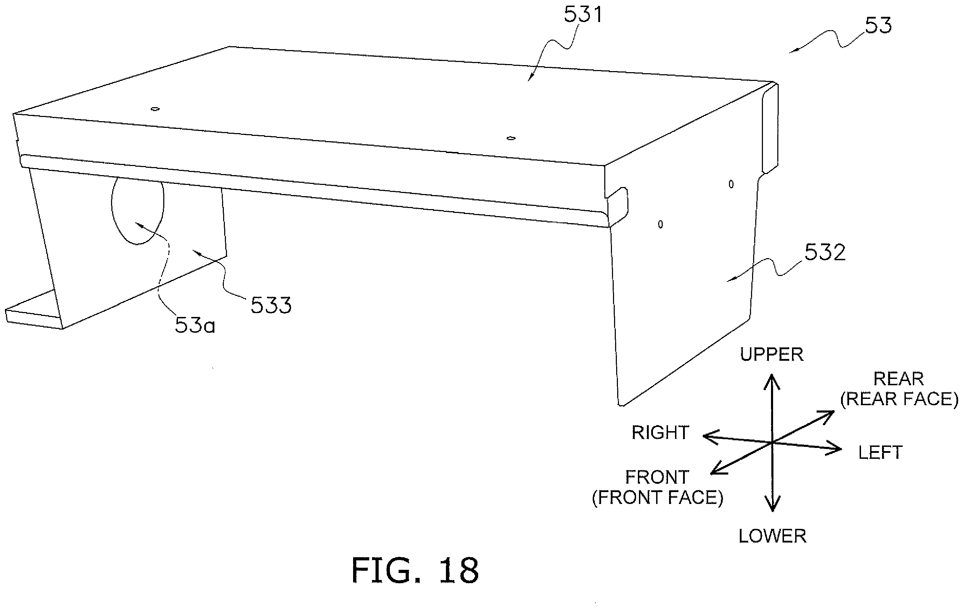

The electric component box 50 includes as its constituent members the front face cover 51 (see FIG. 7), a main body frame 52 (see FIGS. 14 and 15), and a top face cover 53 (see FIGS. 17 and 18).

### (4-2-1) Front Face Cover 51

The front face cover 51 is substantially a rectangular plate-shaped member constituting a front face portion of the electric component box 50. The front face cover 51 is substantially equal in widthwise length and heightwise length to the electric component box 50.

### (4-2-2) Main Body Frame 52

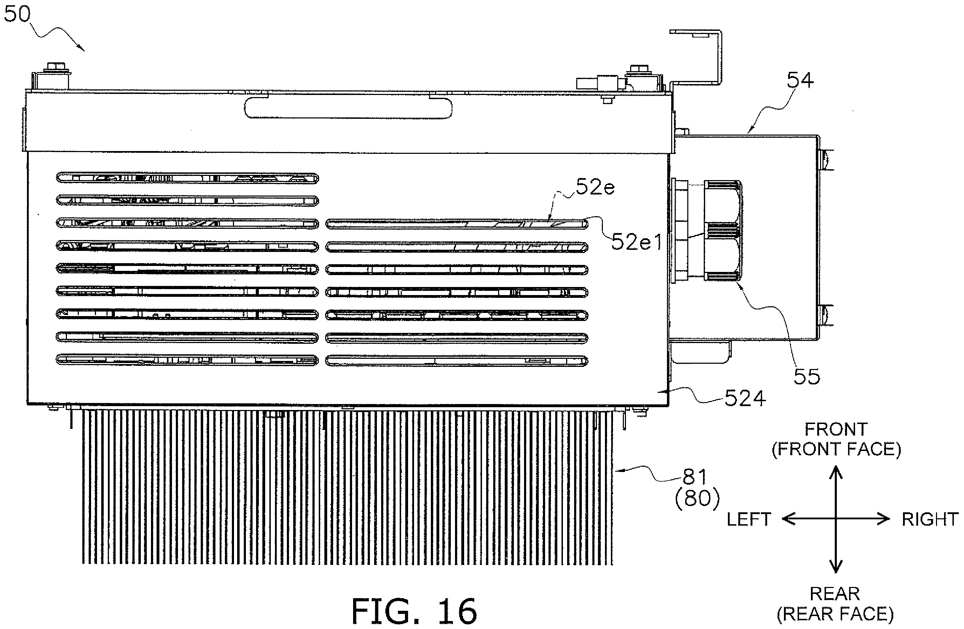

FIG. 14 is a front perspective view of the main body frame 52. FIG. 15 is a front perspective view of the main body frame 52 seen from an angle different from that in FIG. 14. FIG. 16 is a top view of the electric component box 50 from which the top face cover 53 is detached.

The main body frame 52 is a housing that is made of metal and constitutes a main body portion of the electric component box 50. The main body frame 52 includes: a rear face part 521 constituting a rear face portion of the electric component box 50; a left side face part 522 constituting a left side face portion of the electric component box 50; a right side face part 523 constituting a right side face portion of the electric component box 50; and a top face part 524 constituting the top face portion of the electric component box 50.

The rear face part 521 has substantially a rectangular shape, and is substantially equal in dimensions to the front face cover 51. The left side face part 522 has substantially a rectangular shape, and extends forward from a left-side end of the rear face part 521. The right side face part 523 has substantially a rectangular shape, and extends forward from a right-side end of the rear face part 521. The top face part 524 has substantially a rectangular shape, and is connected to an upper end portion of the rear face part 521, an upper end portion of the left side face part 522, and an upper end portion of the right side face part 523. Each of the rear face part 521, the left side face part 522, and the right side face part 523 has a lower end portion bent horizontally and elongated along the bottom frame 43 such that the main body frame 52 is disposed upright on the bottom frame 43 of the outdoor unit casing 40.

The main body frame 52 (the rear face part 521) has a plurality of openings. Specifically, the main body frame 52 has a first opening 52a from which first heat radiating fins (first cooling unit fins 81 to be described later) of the first cooling unit 80 are exposed to the blowing space S1. The first opening 52a is formed at a position corresponding to a position at which the first cooling unit 80 and compressor control board 76 are disposed.

The main body frame 52 (the rear face part 521) also has second openings 52b from which second heat radiating fins (second cooling unit fins 86 to be described later) of the second cooling units 85 are exposed to the blowing space S1. The second openings 52b are equal in number (two in this embodiment) to the second cooling units 85. The second openings 52b are in one-to-one correspondence with the second cooling units 85. The second heat radiating fins of the second cooling units 85 are respectively exposed from the second openings 52b. Each of the second openings 52b is located below the first opening 52a, and is formed at a position corresponding to a position where the corresponding second cooling unit 85 and fan control board 77 are disposed.

The main body frame 52 (the right side face part 523) also has a third opening 52c through which electric wires (high-voltage wires, low-voltage wires) connected to electric components mounted on the control boards 71, compressor control board 76, and fan control boards 77 are drawn into the electric component box 50. The third opening 52c is formed at a position corresponding to the upper space SP2, by cutting a part of the right side face part 523 into substantially a U shape or substantially a C shape.

The main body frame 52 (the right side face part 523) also has a fourth opening 52d through which power wires connected to the compressor 12 are drawn into the electric component box 50. The fourth opening 52d is located above the third opening 52c, and is formed by punching a part of the right side face part 523 into substantially an O shape.

The main body frame 52 (the top face part 524) also has a plurality of fifth openings 52e each functioning as an "exhaust port" through which air is discharged from the electric component box 50. In this embodiment, each fifth opening 52e is a slit extending in the left-right direction. As illustrated in FIG. 16, in the top face part 524, a plurality of the fifth openings 52e arranged in the depth direction (the front-rear direction) are formed in two rows in the width direction (the left-right direction). In the state in which the electric component box 50 is disposed in the outdoor unit casing 40, the fifth openings 52e are lower in heightwise position than the outdoor fans 18 and higher in heightwise position than the first heat radiating fins (the first cooling unit fins 81 to be described later) of the first cooling unit 80. As illustrated in FIG. 16, each fifth hole 52e is subjected to burring, so that an edge portion (a fifth opening edge part 52e1) of each fifth opening 52e extends upward. Such fifth opening edge parts 52e1 suppress the entry of liquid into the inner space SP through the fifth openings 52e even when the liquid adheres to an upper face of the top face part 524.

The main body frame 52 (the rear face part 521) also has, near its lower end, a sixth opening 52f through which a service engineer accesses the compressor 12 for maintenance and other purposes.

### (4-2-3) Top Face Cover 53

FIG. 17 is a perspective view of the top face cover 53. FIG. 18 is a perspective view of the top face cover 53 seen from an angle different from that in FIG. 17.

The top face cover 53 (which is an example of a "cover part" in the claims) is a sheet metal member covering an upper end portion of the main body frame 52 from above so as to suppress the entry of liquid into the inner space SP through the fifth openings 52e in the top face part 524 of the main body frame 52. The top face cover 53 is upwardly spaced apart from the fifth openings 52e. The top face cover 53 includes an upper cover part 531, a left lateral cover part 532, and a right lateral cover part 533.

The upper cover part 531 is a portion covering the top face part 524 (the fifth openings 52e) of the main body frame 52 from above. The upper cover part 531 has substantially a rectangular shape in plan view, and is larger in area than the top face part 524 of the main body frame 52.

The left lateral cover part 532 externally covers a portion near an upper end of the left side face part 522 of the main body frame 52. The left lateral cover part 532 is a portion extending downward from a left end of the upper cover part 531.

The right lateral cover part 533 externally covers a portion near an upper end of the right side face part 523 of the main body frame 52. The right lateral cover part 533 is a portion extending downward from a right end of the upper cover part 531. The right lateral cover part 533 has an opening 53a at a position superimposed on the fourth opening 52d.

### (5) First Side Face Cover 54 and Second Side Face Cover 55

The electric component box 50 includes a first side face cover 54 configured to suppress the entry of liquid into the inner space SP through the third opening 52c in the right side face part 523, and a second side face cover 55 configured to suppress the entry of liquid into the inner space SP through the fourth opening 52d in the right side face part 523.

### (5-1) First Side Face Cover 54

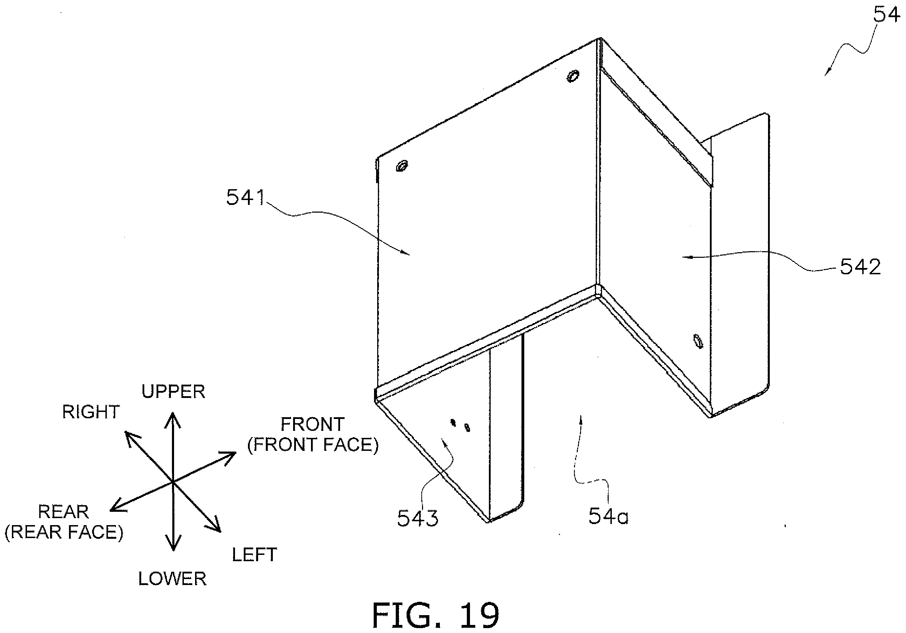

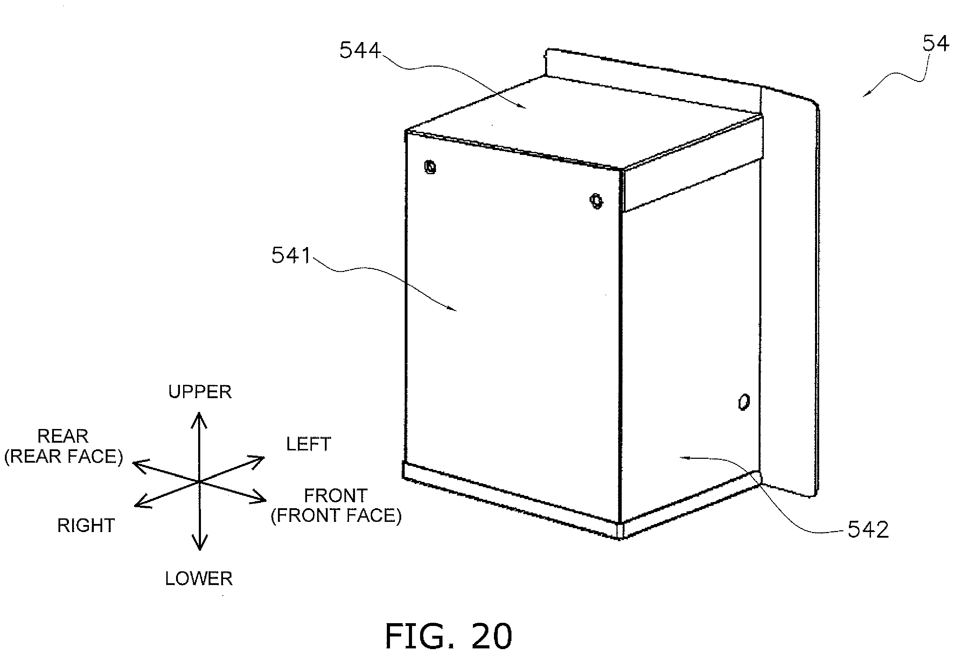

FIG. 19 is a perspective view of the first side face cover 54. FIG. 20 is a perspective view of the first side face cover 54 seen from an angle different from that in FIG. 19.

The first side face cover 54 is a sheet metal member externally covering the third opening 52c in the right side face part 523 of the main body frame 52 from above and from sideward so as to suppress the entry of liquid into the inner space SP through the third opening 52c in the main body frame 52. The first side face cover 54 includes a right-side part 541, a front-side part 542, a rear-side part 543, and an upper part 544.

The right-side part 541 is a portion covering the third opening 52c from a right side of the third opening 52c. The right-side part 541 has substantially a rectangular shape.

The front-side part 542 is a portion covering the third opening 52c from a front side of the third opening 52c. The front-side part 542 has substantially a rectangular shape.

The rear-side part 543 is a portion covering the third opening 52c from a rear side of the third opening 52c. The rear-side part 543 has substantially a rectangular shape.

The upper part 544 is a portion covering the third opening 52c from an upper side of the third opening 52c. The upper part 544 has substantially a rectangular shape.

The first side face cover 54 has a bottom portion that is open. In other words, the first side face cover 54 has an open portion 54a that is open downward. The open portion 54a functions as an opening through which the electric wires to be drawn into the inner space SP through the third opening 52c pass.

### (5-2) Second Side Face Cover 55

As illustrated in, for example, FIGS. 11, 12, 16, and 28, the second side face cover 55 is a cover externally covering the fourth opening 52d in the right side face part 523 of the main body frame 52 from above and from sideward so as to suppress the entry of liquid into the inner space SP through the fourth opening 52d in the main body frame 52. The second side face cover 55 is a general-purpose product that is commonly available. The second side face cover 55 has a plurality of (three in this embodiment) openings through which the power wires connected to the compressor 12 pass.

### (6) First Cooling Unit 80 and Second Cooling Units 85

In the electric component box 50, the first cooling unit 80 and the second cooling units 85 are disposed for cooling the first heat generating components in the inner space SP.

### (6-1) First Cooling Unit 80

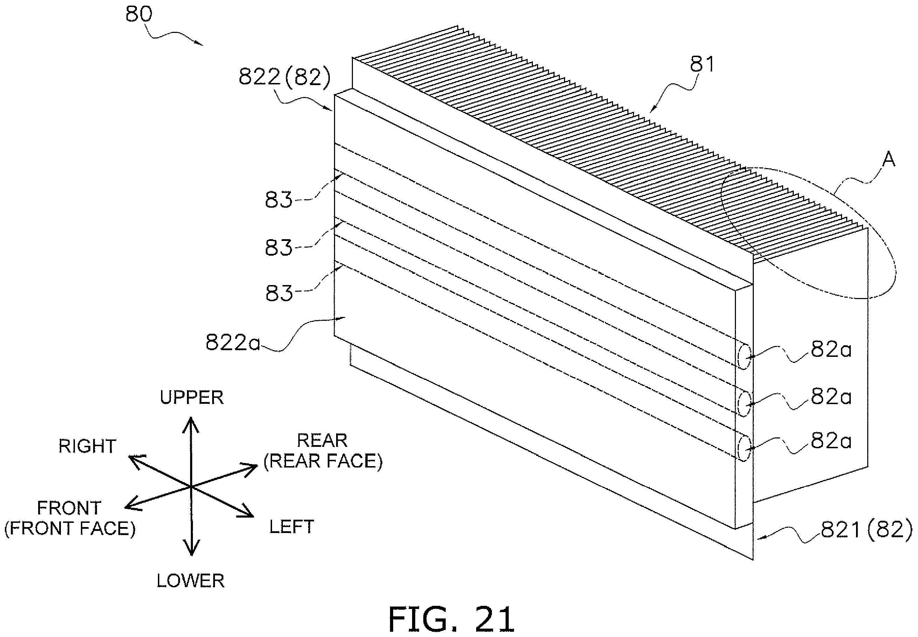

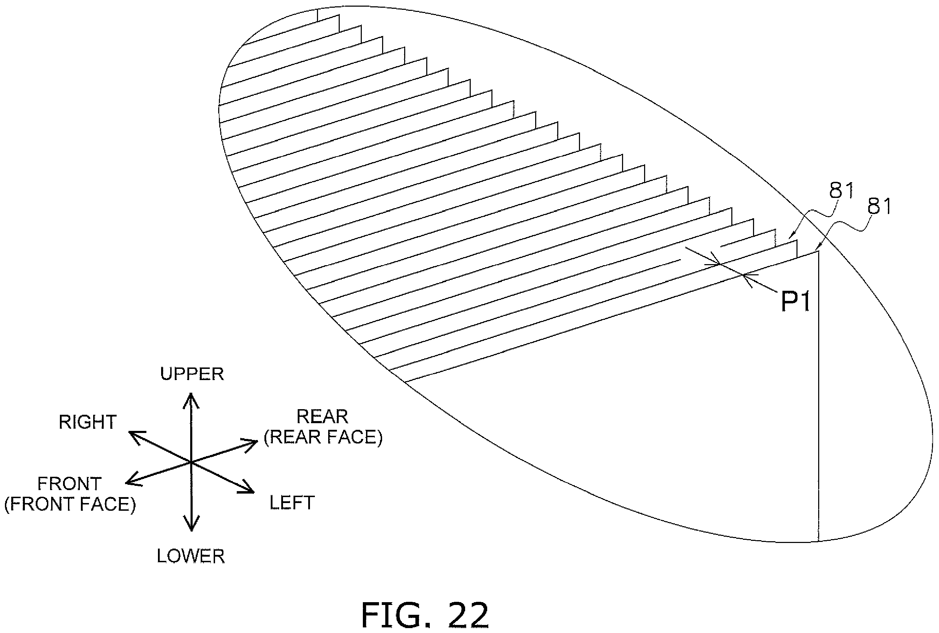

FIG. 21 is a perspective view of the first cooling unit 80. FIG. 22 is an enlarged view of segment A in FIG. 21.

The first cooling unit 80 (which is an example of a "first cooler" in the claims) is a unit for cooling the compressor controlling electric components 63 (mainly the high-heat generating electric component 65) on the compressor control board 76. The first cooling unit 80 is thermally connected to the high-heat generating electric component 65 in an installed state. The first cooling unit 80 includes the plurality of first cooling unit fins 81 for heat exchange with the outdoor air flow AF, a first cooling unit main body 82, and a plurality of (three in this embodiment) heat pipes 83.

Each first cooling unit fin 81 (which is an example of a "heat radiating fin" in the claims) is a plate-shaped fin made of metal. As illustrated in FIG. 22, in the first cooling unit 80, a large number of first cooling unit fins 81 are arranged in the width direction (the left-right direction) with spacings each of which is equal to or more than a predetermined length (a first fin pitch PI). In other words, each first cooling unit fin 81 and another first cooling unit fin 81 adjacent thereto are spaced apart from each other by at least the first fin pitch P1. Each first cooling unit fin 81 has a front-side end connected to the first cooling unit main body 82. The first cooling unit fins 81 are located on a flow path of the outdoor air flow AF in the installed state.

The first cooling unit main body 82 (which is an example of a "main body" in the claims) is a plate-shaped member that is thick and is made of metal. The first cooling unit main body 82 is interposed between the first cooling unit fins 81 and the heat pipes 83 to thermally connect the first cooling unit fins 81 to the heat pipes 83. The first cooling unit main body 82 includes a fin holding part 821 and a heat pipe holding part 822. The fin holding part 821 is integrated with the heat pipe holding part 822.

The fin holding part 821 (which is an example of a "first part" in the claims) is a plate-shaped portion constituting a rear face portion of the first cooling unit main body 82, and is interposed between the first cooling unit fins 81 and the heat pipes 83. The fin holding part 821 thermally connects the first cooling unit fins 81 to the heat pipes 83. The fin holding part 821 is connected to the front-side end of each first cooling unit fin 81 to hold each first cooling unit fin 81. The fin holding part 821 is larger in heightwise length than each first cooling unit fin 81. In addition, the fin holding part 821 has an area that is equal to or more than an area of the first opening 52a as seen from the front face or the rear face (as seen from the front-rear direction). In this regard, the fin holding part 821 closes the first opening 52a to separate the inner space SP from a space outside the electric component box 50 in the installed state.

The heat pipe holding part 822 (which is an example of a "second part" in the claims) is a portion constituting a front face portion of the first cooling unit main body 82. The heat pipe holding part 822 is interposed between the high-heat generating electric component 65 and the heat pipes 83 to thermally connect the high-heat generating electric component 65 to the heat pipes 83 in the installed state. The heat pipe holding part 822 is larger in thickness than the fin holding part 821. The heat pipe holding part 822 has a plurality of heat pipe insertion holes 82a into which the heat pipes 83 are inserted horizontally (the left-right direction in this embodiment). The heat pipe insertion holes 82a are equal in number to the heat pipes 83. The heat pipe holding part 822 is smaller in heightwise length than the fin holding part 821. The heat pipe holding part 822 has a front face part 822a directed to the front face, and is in contact at the front face part 822a with the high-heat generating electric component 65.

Each heat pipe 83 is a metal tube (e.g., a copper tube) in which a coolant for cooling the high-heat generating electric component 65 is sealed. The coolant sealed in each heat pipe 83 exchanges heat with the high-heat generating electric component 65. The coolant is selected in accordance with design specifications and installation environments. The coolant is, for example, water. The heat pipes 83 are respectively inserted into the heat pipe insertion holes 82a. In other words, the heat pipes 83 are built in the first cooling unit main body 82 (the heat pipe holding part 822). The heat pipe holding part 822 is crimped with the heat pipes 83 inserted into the heat pipe insertion holes 82a in order to increase an amount of heat to be exchanged between the heat pipes 83 and the electric components by an increase in contact area of the heat pipes 83 with edge portions, where the heat pipe insertion holes 82a are formed, of the heat pipe holding part 822.

The first cooling unit main body 82 in which the heat pipes 83 are built is interposed between the high-heat generating electric component 65 and the first cooling unit fins 81 in the installed state. In other words, the heat pipes 83 are interposed between the high-heat generating electric component 65 and the first cooling unit fins 81, and are thermally connected to both the high-heat generating electric component 65 and the first cooling unit fins 81. Each heat pipe 83 is disposed with its longitudinal axis extending horizontally in the installed state. The state in which "the longitudinal axis extends horizontally" used in this embodiment involves not only a case where the longitudinal axis of each heat pipe 83 exactly extends in the horizontal direction, but also a case where the longitudinal axis of each heat pipe 83 is tilted relative to the horizontal direction within a predetermined angular range (e.g., 30 degrees).

### (6-2) Second Cooling Units 85

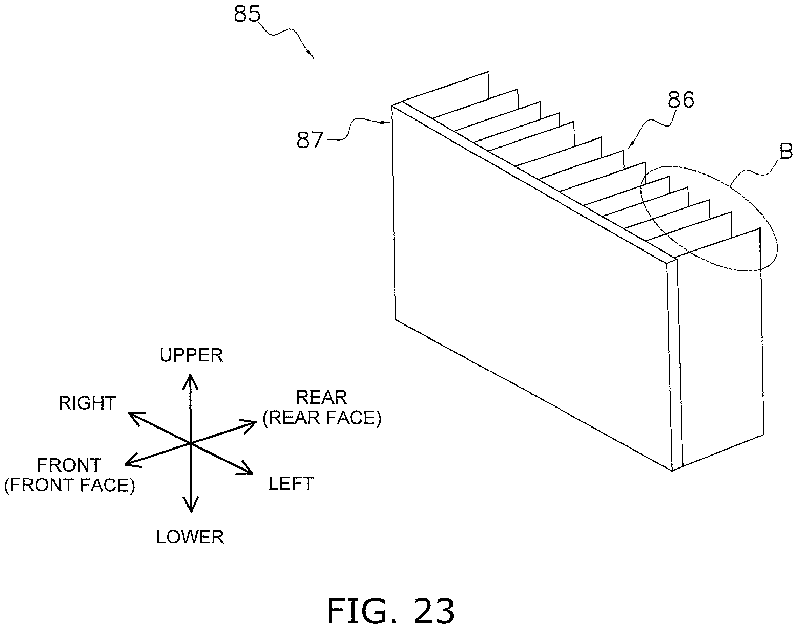

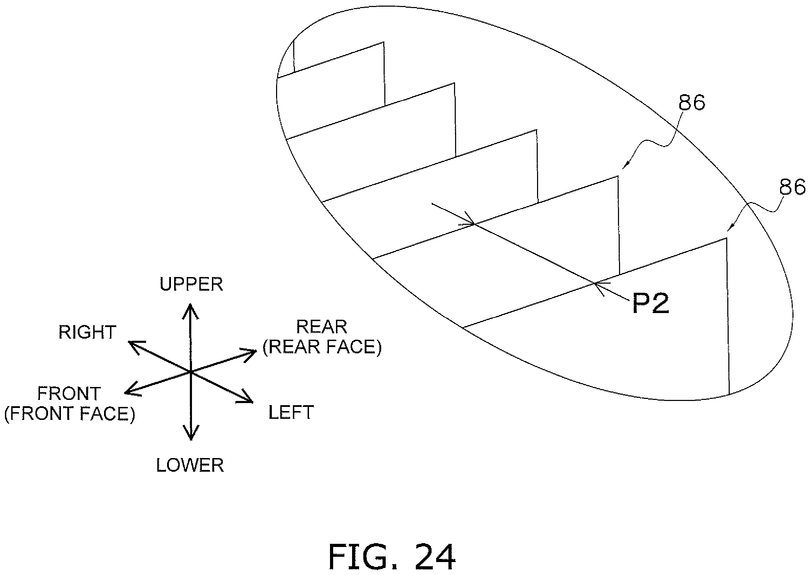

FIG. 23 is a perspective view of one of the second cooling units 85. FIG. 24 is an enlarged view of segment B in FIG. 23.

Each second cooling unit 85 (which is an example of a "second cooler" in the claims) is a unit for cooling the corresponding fan controlling electric component 66 on the fan control board 77. The second cooling units 85 are thermally connected to the fan controlling electric components 66 in the installed state. Each second cooling unit 85 includes the plurality of second cooling unit fins 86 for heat exchange with the outdoor air flow AF, and a second cooling unit main body 87.

Each second cooling unit fin 86 (which is an example of a "second heat radiating fin" in the claims) is a plate-shaped fin made of metal. As illustrated in FIG. 24, in each second cooling unit 85, a large number of second cooling unit fins 86 are arranged in the width direction (the left-right direction) with spacings each of which is equal to or more than a predetermined length (a second fin pitch P2). In other words, each second cooling unit fin 86 and another second cooling unit fin 86 adjacent thereto are spaced apart from each other by at least the second fin pitch P2. Each second cooling unit fin 86 has a front-side end connected to the second cooling unit main body 87. The second cooling unit fins 86 are located on the flow path of the outdoor air flow AF in the installed state.

The second fin pitch P2 is longer than the first fin pitch P1. In this embodiment, the second fin pitch P2 is at least twice as long as the first fin pitch P1. In other words, a density of the second heat radiating fins (the second cooling unit fins 86) of the second cooling unit 85 is lower than a density of the first heat radiating fins of the first cooling unit 80. In this regard, the number of the second heat radiating fins of the second cooling unit 85 is smaller than the number of the first heat radiating fins of the first cooling unit 80. Specifically, in the first cooling unit 80, the first heat radiating fins are arranged with a first fin pitch (the first fin pitch PI) shorter than that in the second cooling units 85. In this regard, the first heat radiating fins (the first cooling unit fins 81) larger in number than those of each second cooling unit 85 are arranged at a higher density.

The second cooling unit main body 87 is a plate-shaped member made of metal. The second cooling unit main body 87 is connected to the front-side end of each second cooling unit fin 86 to hold each second cooling unit fin 86. The second cooling unit main body 87 is larger in heightwise length than each second cooling unit fin 86. In addition, the second cooling unit main body 87 has an area that is equal to or more than an area of the corresponding second opening 52b as seen from the front face or the rear face (as seen from the front-rear direction). In this regard, the second cooling unit main body 87 closes the corresponding second opening 52b to separate the inner space SP from a space outside the electric component box 50 in the installed state. The second cooling unit main body 87 has a front face portion that is in contact with and is thermally connected to the corresponding fan controlling electric component 66 on the fan control board 77 in the installed state.

Each second cooling unit 85 is not provided with a heat pipe unlike the first cooling unit 80, and is smaller in number of first heat radiating fins than the first cooling unit 80. Each second cooling unit 85 is therefore lower in cooling performance than the first cooling unit 80.

### (7) Assembling of Electric Component Box 50

FIG. 25 is a schematic view about how the compressor control board 76, the fan control boards 77, the first cooling unit 80, and the second cooling units 85 are fixed to the main body frame 52.

### (7-1) Fixing of Compressor Control Board 76 and First Cooling Unit 80

First, the high-heat generating electric component 65 (the power module) is fastened to the first cooling unit 80 (specifically, the front face part 822a of the heat pipe holding part 822) with screws. At this time, the high-heat generating electric component 65 is fixed to the first cooling unit 80 in close contact with the front face part 822a so as to facilitate heat exchange with the heat pipes 83. Thereafter, the high-heat generating electric component 65 fixed to the first cooling unit 80 is mounted on the rear face side of the compressor control board 76.

Thereafter, the compressor control board 76 and the first cooling unit 80 to which the high-heat generating electric component 65 is fixed are fastened to a first fitting 57 with screws independently of each other.

The first fitting 57 is a metal sheet for fixing the first cooling unit 80 and the compressor control board 76 to the main body frame 52. The first fitting 57 is fastened to the periphery of the first opening 52a in the main body frame 52 (the rear face part 521) with screws. The first fitting 57 has substantially a rectangular shape. The first fitting 57 has in its center a large opening through which the first cooling unit fins 81 pass.

The compressor control board 76 and the first cooling unit 80 are not necessarily fixed as described above, and may be fixed in any manner. For example, the high-heat generating electric component 65 and the compressor control board 76 may be fastened to the first cooling unit 80 or the first fitting 57 with screws after the first cooling unit 80 is fixed to the main body frame 52 via the first fitting 57.

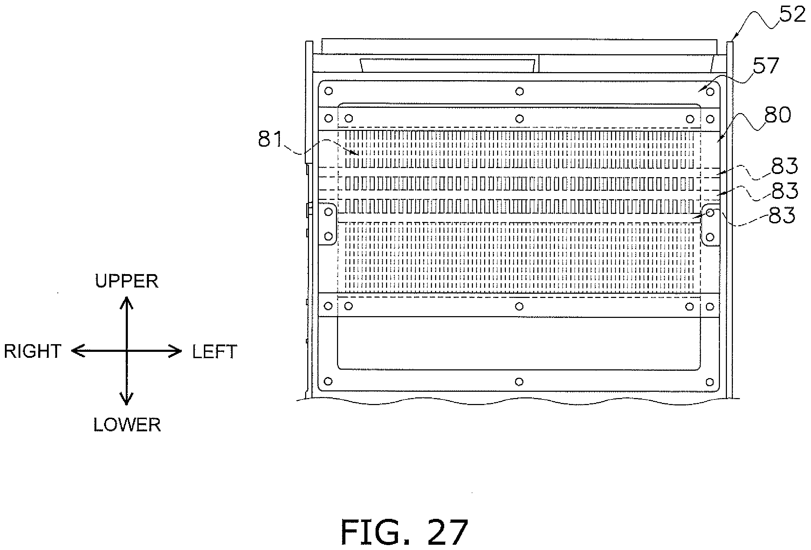

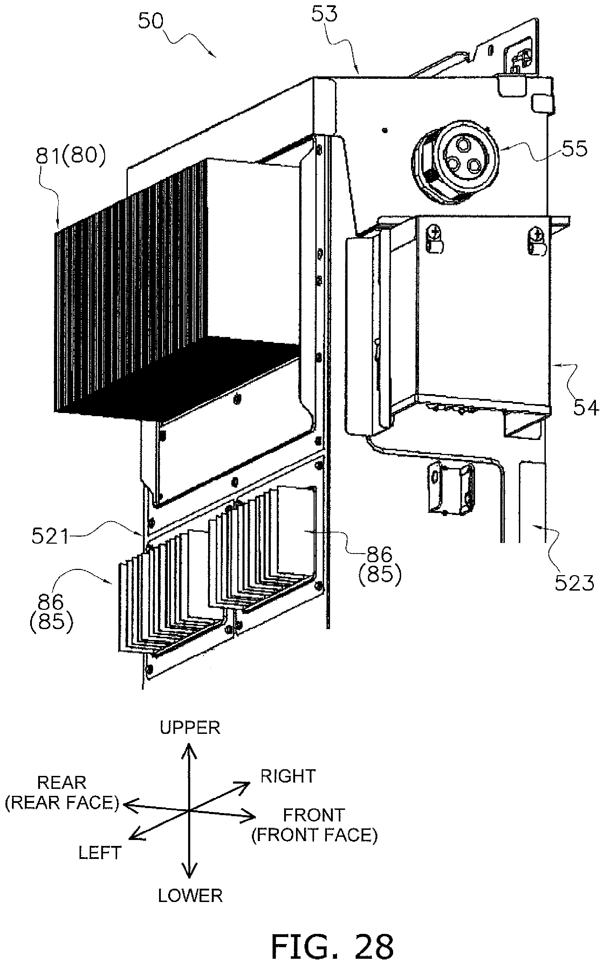

FIG. 26 is a front perspective view of the high-heat generating electric component 65 (the power module) fixed to the first cooling unit 80. FIG. 27 is a front view of the first cooling unit 80 fixed to the main body frame 52. FIG. 28 is a rear perspective view of the first cooling unit 80 and the second cooling units 85 in the installed state.

As illustrated in FIG. 28, the first cooling unit fins 81 extend rearward through the first opening 52a and protrude toward the space (the blowing space S1) outside the electric component box 50 so as to exchange heat with the outdoor air flow AF in the installed state. The first cooling unit main body 82 (the fin holding part 821) closes the first opening 52a to separate the inner space SP from the space outside the electric component box 50. In the electric component box 50, the heat pipes 83 of the first cooling unit 80 are housed in the heat pipe holding part 822, and are shielded from the space (mainly the blowing space S1) outside the electric component box 50 in the installed state. The first cooling unit 80 is adjacent to the compressor control board 76 (the compressor controlling electric component mount portion 75a) in the installed state. In this regard, the heat pipes 83 are adjacent to the high-heat generating electric component 65 so as to exchange heat with the high-heat generating electric component 65.

### (7-2) Fixing of Fan Control Boards 77 and Second Cooling Units 85

First, the fan control boards 77 are respectively fastened to the second cooling units 85 (specifically, the second cooling unit main bodies 87) with screws. At this time, the fan control boards 77 are fixed to the second cooling units 85 such that the fan controlling electric components 66 are in close contact with the second cooling unit main bodies 87 in order to facilitate cooling of the fan controlling electric components 66.

Thereafter, the second cooling units 85 and fan control boards 77 are respectively fastened to second fittings 58 with screws independently of each other.

Each second fitting 58 is a metal sheet for fixing the corresponding second cooling unit 85 and fan control board 77 to the main body frame 52. Each second fitting 58 is fastened to the periphery of the corresponding second opening 52b in the main body frame 52 (the rear face part 521) with screws. Each second fitting 58 has substantially a rectangular shape. Each second fitting 58 has in its center a large opening through which the second cooling unit fins 86 pass.

The fan control boards 77 and the second cooling units 85 are not necessarily fixed as described above, and may be fixed in any manner. For example, the fan control boards 77 may be fastened to the second cooling units 85 or the second fittings 58 with screws after the second cooling units 85 are fixed to the main body frame 52 via the second fittings 58.

As illustrated in FIG. 28, the second cooling unit fins 86 respectively extend rearward through the second openings 52b and protrude toward the space (the blowing space S1) outside the electric component box 50 so as to exchange heat with the outdoor air flow AF in the installed state. The second cooling unit main body 87 closes the second openings 52b to separate the inner space SP from the space outside the electric component box 50. Each second cooling unit 85 is adjacent to the corresponding fan control board 77 in the installed state.

### (8) Cooling of Compressor Controlling Electric Components 63 and Fan Controlling Electric Components 66

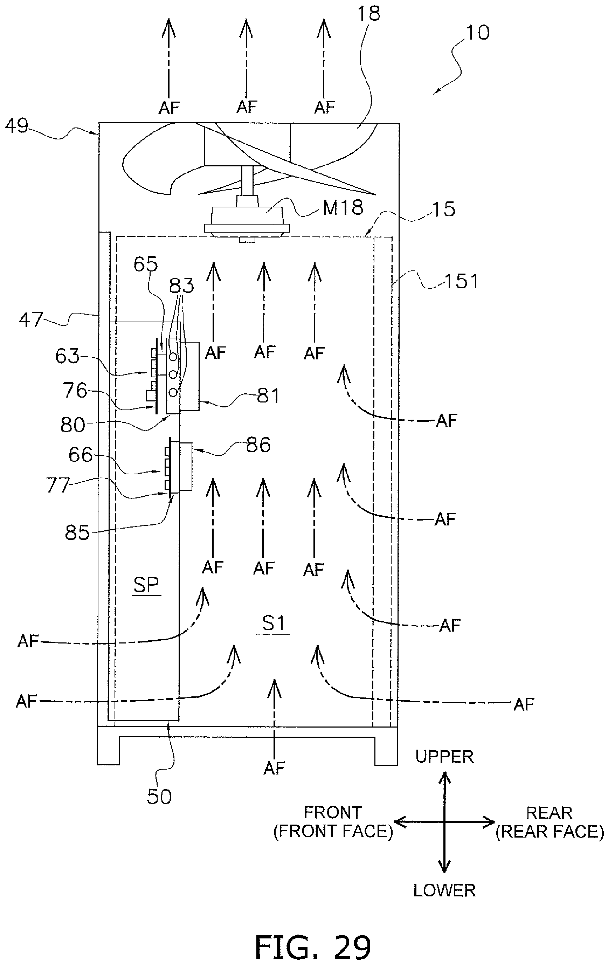

FIG. 29 is a schematic view of a relationship between the positions of the compressor control board 76 (high-heat generating electric component 65), first cooling unit 80 (first cooling unit fins 81), fan control boards 77 (fan controlling electric components 66), and second cooling units 85 (second cooling unit fins 86) and the air flow path of the outdoor air flow AF.

As described above, the outdoor air flow AF flow into the outdoor unit casing 40 through the intake ports 401 in the left side face, right side face, and rear face of the outdoor unit casing 40, and pass through the outdoor heat exchanger 15 (the heat exchange faces 151). The outdoor air flow AF then mainly flow from below upward. As illustrated in FIG. 29, the first cooling unit 80 is adjacent to the compressor control board 76 (the high-heat generating electric component 65), and the first cooling unit fins 81 are located on the flow path of the outdoor air flow AF. In addition, the second cooling units 85 are respectively adjacent to the fan control boards 77 (the fan controlling electric components 66), and the second cooling unit fins 86 are located on the flow path of the outdoor air flow AF.

During operation, in the outdoor unit 10, the high-heat generating electric component 65 on the compressor control board 76 is cooled by heat exchange with the coolant in each heat pipe 83 of the first cooling unit 80. The heat of the coolant in each heat pipe 83 heated by the heat exchange with the high-heat generating electric component 65 is transmitted to the first cooling unit fins 81, and then is radiated to the outdoor air flow AF. In other words, the heat pipes 83 for cooling the high-heat generating electric component 65 are cooled by heat exchange with the outdoor air flow AF via the first cooling unit fins 81. In other words, the high-heat generating electric component 65 is cooled by heat exchange with the outdoor air flow AF via the heat pipes 83 and the first cooling unit fins 81.

In addition, the fan controlling electric components 66 on the fan control boards 77 are cooled by heat exchange with the outdoor air flow AF via the second cooling unit fins 86 of the second cooling units 85.

As illustrated in FIG. 29, the first cooling unit fins 81 are lower in heightwise position than the outdoor fans 18 and higher in heightwise position than the second cooling unit fins 86. In other words, the first cooling unit fins 81 are at the downwind side of the second cooling unit fins 86. In this regard, the first cooling unit 80 exchanges heat with the outdoor air flow AF subjected to heat exchange with the second cooling unit fins 86. In other words, the second cooling unit fins 86 exchange heat with outdoor air flow AF before being subjected to heat exchange with the first cooling unit 80.

In addition, the first cooling unit fins 81 are closer in heightwise position to the outdoor fans 18 than the second cooling unit fins 86 are. In this regard, the outdoor air flow AF passing around the first cooling unit 80 are larger in airflow volume than the outdoor air flow AF passing around the second cooling unit fins 86.

In addition, the heat pipes 83 are separated from the blowing space S1 and are shielded from the outdoor air flow AF by the first cooling unit main body 82 (the fin holding part 821, the heat pipe holding part 822). In this regard, the weather resistance of each heat pipe 83 is enhanced.

### (9) Features

### (9-1)

In some outdoor units for a refrigeration apparatus, a power device such as an IGBT or a power module including the power device is particularly larger in heating value than other heat generating components, and is therefore cooled by a heat pipe that is excellent in cooling performance. However, since a heat pipe has been disposed in an blowing space (a space where the main flow path of the air flow provided by a fan is formed), it is supposed that the heat pipe may undergo deformation, damage, and electrolytic corrosion caused by contact with another device and may also undergo deterioration, corrosion, alteration, and the like caused by direct exposure to an air flow, which may result in decrease in weather resistance. The deformation, damage, electrolytic corrosion, deterioration, corrosion, and alteration of the heat pipe hinder the heat pipe from exerting its satisfactory cooling performance, which may cause the heat pipe to unsatisfactorily cool a first heat generating component. This situation may in turn cause decrease in reliability.

In this respect, in the outdoor unit 10 according to this embodiment, the first cooling unit 80 configured to cool the high-heat generating electric component 65 includes the heat pipes 83 in which the coolant for heat exchange with the high-heat generating electric component 65 is sealed. In addition, the heat pipes 83 are located in the electric component box 50, and are adjacent to the high-heat generating electric component 65. In other words, the heat pipes 83 configured to cool the high-heat generating electric component 65 are located in the electric component box 50. The heat pipes 83 are thus shielded from the space (e.g., the air blowing space S1) outside the electric component box 50. As a result, this configuration suppresses a situation in which the heat pipes 83 undergo deformation, damage, and electrolytic corrosion because of contact with another device, and also undergo deterioration, corrosion, and alteration because of direct exposure to an outdoor air flow AF. This configuration thus suppresses decrease in cooling performance of the heat pipes 83 because of decrease in weather resistance of the heat pipes 83. This configuration therefore suppresses decrease in reliability.

### (9-2)

In the outdoor unit 10 according to this embodiment, the electric component box 50 has the first opening 52a from which the first cooling unit fins 81 are exposed, and the area of the first cooling unit main body 82 is equal to or more than the area of the first opening 52a. The first cooling unit 80 is fixed to the electric component box 50 with each first cooling unit fin 81 protruding out of the electric component box 50 through the first opening 52a and with the first cooling unit main body 82 closing the first opening 52a. This configuration enables satisfactory heat exchange between the first cooling unit fins 81 and the outdoor air flow AF from the outdoor fans 18, and also enables reliable shielding of the heat pipes 83 from the outdoor air flow AF. This configuration thus particularly suppresses decrease in weather resistance of the heat pipes 83.

### (9-3)

In the outdoor unit 10 according to this embodiment, the first cooling unit main body 82 includes: the fin holding part 821 interposed between the heat pipes 83 and the first cooling unit fins 81 to thermally connect the heat pipes 83 to the first cooling unit fins 81; and the heat pipe holding part 822 interposed between the high-heat generating electric component 65 and the heat pipes 83 to thermally connect the high-heat generating electric component 65 to the heat pipes 83.

This configuration enables shielding of the heat pipes 83 from the blowing space S1, and suppresses direct contact of the heat pipes 83 with the high-heat generating electric component 65. In other words, the heat pipes 83 are shielded by the first cooling unit main body 82 in the installed state. This configuration thus particularly suppresses decrease in weather resistance of the heat pipes 83.

### (9-4)

In the outdoor unit 10 according to this embodiment, each heat pipe 83 is disposed with its longitudinal axis extending horizontally. This configuration suppresses a situation in which the coolant frozen in each heat pipe 83 bursts the heat pipe 83 (frost bursting). Specifically, the configuration in that each heat pipe 83 is disposed in the horizontal direction suppresses freezing of the coolant even under an environment of low outside temperature. This configuration therefore suppresses decrease in reliability because of frost bursting in cooling the electric components using the heat pipes 83.

### (9-5)

In the outdoor unit 10 according to this embodiment, the high-heat generating electric component 65 includes a power device or a power module including the power device. Specifically, the outdoor unit 10 ensures a satisfactory cooling value of the high-heat generating electric component 65 having a larger heating value, and suppresses decrease in weather resistance of the heat pipes 83.

### (9-6)

The outdoor unit 10 according to this embodiment further includes: the fan controlling electric components 66; the fan control boards 77 on which the fan controlling electric components 66 are mounted; and the second cooling units 85 thermally connected to the fan controlling electric components 66 and configured to cool the fan controlling electric components 66. Each of the second cooling units 85 includes the plurality of second cooling unit fins 86 configured to exchange heat with the outdoor air flow AF.

In the outdoor unit 10, as described above, the high-heat generating electric component 65 having a larger heating value is cooled by the heat pipes 83. This configuration ensures a cooling value. On the other hand, the fan controlling electric components 66 smaller in heating value than the high-heat generating electric component 65 are cooled by the first cooling unit fins 81. This configuration suppresses decrease in reliability, and reduces cost. In other words, in the outdoor unit 10, only the high-heat generating electric component 65, which is unsatisfactorily cooled by only the first cooling unit fins 81, is cooled by the heat pipes 83, and another high-heat generating electric component 65 is cooled by the first cooling unit fins 81. This configuration suppresses unnecessary increase in number of heat pipes 83, which leads to cost cutting.

### (9-7)

In the outdoor unit 10 according to this embodiment, the first cooling unit fins 81 of the first cooling unit 80 are arranged with the first fin pitch P1. The second cooling unit fins 86 of the second cooling units 85 are arranged with the second fin pitch P2. The first fin pitch P1 is shorter than the second fin pitch P2. In the outdoor unit 10, when the first fin pitch between the first cooling unit fins 81 of the first cooling unit 80 is shorter than the second fin pitch between the second cooling unit fins 86 of the second cooling units 85, the number of first cooling unit fins 81 is increased. In this regard, this configuration improves heat radiating performance of the first cooling unit fins 81 of the first cooling unit 80.

### (9-8)

In the outdoor unit 10 according to this embodiment, the first cooling unit fins 81 are lower in heightwise position than the outdoor fans 18 and higher in heightwise position than the second cooling unit fins 86.

When the first fin pitch (the first fin pitch P1) between the first cooling unit fins 81 is shorter than the second fin pitch (the second fin pitch P2) between the second cooling unit fins 86, heat exchange with the outdoor air flow AF is facilitated in the first cooling unit 80, which leads to improvement in cooling performance. Meanwhile, an airflow volume of outdoor air flow AF passing the first cooling unit 80 needs to be larger than an airflow volume of outdoor air flow AF passing the second cooling units 85 in order that each first cooling unit fin 81 favorably exchanges heat with an outdoor air flow AF. Specifically, when the first cooling unit fins 81 are arranged with a shorter first fin pitch (the first fin pitch P1), the number of first cooling unit fins 81 is increased, which leads to improvement in heat radiating performance. However, the first cooling unit fins 81 are arranged at a higher density, which may result in a situation in which an outdoor air flow AF is less prone to favorably pass between two of the first cooling unit fins 81. In view of this, in order to arrange the first cooling unit fins 81 with a shorter first fin pitch (the first fin pitch PI), it is necessary to increase an airflow volume of outdoor air flow AF passing the first cooling unit fins 81 in accordance with the first fin pitch (the first fin pitch PI) such that an outdoor air flow AF favorably passes between two of the first cooling unit fins 81 from the viewpoint of allowing each first cooling unit fin 81 to satisfactorily exchange heat with an outdoor air flow AF.

In the outdoor unit 10 according to this embodiment, the first cooling unit fins 81 of the first cooling unit 80 are arranged with a first fin pitch (the first fin pitch PI) that is shorter than that between the second cooling unit fins 86 of the second cooling units 85. The first cooling unit fins 81 are lower in heightwise position than the outdoor fans 18 and higher in heightwise position than the second cooling unit fins 86 (i.e., closer to the outdoor fans 18 than the second cooling unit fins 86 are). This configuration thus facilitates improvement in cooling performance of the first cooling unit 80.

Specifically, when the first fin pitch (the first fin pitch PI) between the first cooling unit fins 81 of the first cooling unit 80 is shorter than the second fin pitch (the second fin pitch P2) between the second cooling unit fins 86 of each second cooling unit 85, the number of first cooling unit fins 81 is increased. In addition, the airflow volume of outdoor air flow AF passing the first cooling unit fins 81 of the first cooling unit 80 is ensured to be larger than the airflow volume of outdoor air flow AF passing the second cooling unit fins 86. As a result, the airflow volume of outdoor air flow AF passing the first cooling unit fins 81 is increased in accordance with the first fin pitch (the first fin pitch PI) such that an outdoor air flow AF favorably passes between two of the first cooling unit fins 81, which leads to suppression of the situation in which an outdoor air flow AF is less prone to favorably pass between two of the first cooling unit fins 81. This configuration thus facilitates improvement in cooling performance of the first cooling unit 80.

### (9-9)

In the outdoor unit 10 according to this embodiment, the fifth openings 52e (the exhaust ports) in the electric component box 50 are lower in heightwise position than the outdoor fans 18 and higher in heightwise position than the first cooling unit fins 81. In other words, the fifth openings 52e in the electric component box 50 are at the downwind side of the first cooling unit fins 81. This configuration suppresses a situation in which the outdoor air flow AF for heat exchange with the first cooling unit fins 81 are heated by air to be discharged through the fifth openings 52e in the electric component box 50. This configuration thus suppresses a situation in which the air discharged from the electric component box 50 causes a small temperature difference between the first cooling unit fins 81 and the outdoor air flow AF, and suppresses reduction in cooling value of the high-heat generating electric component 65.

### (9-10)

In the outdoor unit 10 according to this embodiment, the electric component box 50 includes the top face cover 53 spaced apart from the fifth openings 52e, located on the upper side of the electric component box 50, and configured to suppress the entry of liquid into the fifth openings 52e. This configuration therefore reliably suppresses the entry of liquid into the electric component box 50 through the fifth openings 52e, and improves reliability for a short circuit, corrosion, and the like as to each electric component.

### (10) Modifications

The foregoing embodiment may be appropriately modified as described in the following modifications. It should be noted that these modifications are applicable in conjunction with other modifications insofar as there are no consistencies.

### (10-1) Modification 1

In the foregoing embodiment, the outdoor unit 10 is of an upward blowing type. Specifically, the outdoor unit 10 has in its top face the blow-out port 402, and outdoor air flow AF mainly flow from below upward in the outdoor unit casing 40, and are blown out upward through the blow-out port 402. However, the present invention is not limited thereto. The outdoor unit 10 may be of any type.

For example, the outdoor unit 10 may be of a sideward blowing type. Specifically, the outdoor unit 10 has in its front face portion the blow-out port 402, and the outdoor air flow AF is blown out horizontally through the blow-out port 402. In this case, the outdoor fan 18 may be disposed to provide the outdoor air flow AF mainly flowing horizontally in the outdoor unit casing 40. In other words, the outdoor fan 18 may be disposed such that its axis extends horizontally.

### (10-2) Modification 2

In the foregoing embodiment, the first cooling unit main body 82 (the fin holding part 821) has the area that is equal to or more than the area of the first opening 52a as seen from the front face or the rear face (as seen from the front-rear direction). In this regard, the first cooling unit main body 82 (the fin holding part 821) is disposed to close the first opening 52a and to separate the inner space SP from the space outside the electric component box 50. In this respect, preferably, the first cooling unit main body 82 is disposed as described above from the viewpoint of reliably shielding the heat pipes 83 from the outdoor air flow AF and suppressing decrease in weather resistance of the heat pipes 83.

However, the configuration of the first cooling unit main body 82 may be appropriately changed as long as the heat pipes 83 do not extend from the space (the inner space SP) inside the electric component box 50 to the blowing space S1 outside the electric component box and there arises no contradiction as to the functions and effects described in Feature (9-1). For example, the first cooling unit main body 82 may be smaller in area than the first opening 52a. Alternatively, the first cooling unit main body 82 does not necessarily close the entire first opening 52a in the installed state.

### (10-3) Modification 3

The configuration of the first cooling unit 80 is not limited to that described in the foregoing embodiment, and may be appropriately changed in accordance with design specifications and installation environments.

In the foregoing embodiment, for example, the front face part 822a of the first cooling unit main body 82 (the heat pipe holding part 822) is interposed between the heat pipes 83 and the high-heat generating electric component 65. In this respect, preferably, an object is interposed between the heat pipes 83 and the high-heat generating electric component 65 to avoid direct contact of the heat pipes 83 with the high-heat generating electric component 65, from the viewpoint of avoiding direct contact of the heat pipes 83 with the high-heat generating electric component 65, thereby suppressing deformation, damage, deterioration, corrosion, and the like of the heat pipes. However, such an object is not necessarily interposed between the heat pipes 83 and the high-heat generating electric component 65 as long as the functions and effects described in Feature (9-1) (the functions and effects of suppressing decrease in weather resistance of the heat pipes 83 in such a manner that the heat pipes 83 are shielded from the space outside the electric component box 50) are produced. In other words, the heat pipes 83 may be provided in direct contact with the high-heat generating electric component 65.

### (10-4) Modification 4

In the foregoing embodiment, on the assumption that the outdoor unit 10' includes two outdoor fans 18, two fan control boards 77 (fan controlling electric components 66) are arranged side by side in the left-right direction in the electric component box 50. As illustrated in, for example, FIGS. 2 to 4, however, one fan control board 77 may be disposed in the electric component box 50 as to the outdoor unit 10 including one outdoor fan 18. In other words, one of the fan control boards 77 illustrated in, for example, FIGS. 12 and 25 may be appropriately omitted. In such a case, the second cooling unit 85 corresponding to the omitted fan control board 77 is also omitted.

### (10-5) Modification 5

In the foregoing embodiment, the board unit 75 includes the compressor control board 76 and the fan control boards 77, the compressor controlling electric component mount portion 75a is disposed on the compressor control board 76, and the fan controlling electric component mount portions 75b are respectively disposed on the fan control boards 77. In the foregoing embodiment, specifically, the high-heat generating electric component 65 is mounted on the compressor control board 76, and the fan controlling electric components 66 are respectively mounted on the fan control boards 77. In other words, the high-heat generating electric component 65 and the fan controlling electric components 66 are respectively mounted on the different boards.

However, the present invention is not limited thereto. Alternatively, the high-heat generating electric component 65 and the fan controlling electric components 66 may be mounted on a single board. In other words, the compressor controlling electric component mount portion 75a and the fan controlling electric component mount portions 75b may be disposed on a single board.

This case also produces functions and effects similar to those produced by the foregoing embodiment as long as the first cooling unit 80 (the first cooling unit fins 81) adjacent to the compressor controlling electric component mount portion 75a is at the leeward side of the second cooling units 85 (the second cooling unit fins 86) adjacent to the fan controlling electric component mount portions 75b and is closer in heightwise position to the outdoor fans 18 than the second cooling units 85 (the second cooling unit fins 86) are, as described in the foregoing embodiment. In other words, the board unit 75 does not necessarily include a plurality of boards.

### (10-6) Modification 6

In the foregoing embodiment, the high-heat generating electric component 65 (the power module) is fixed to the first cooling unit 80 in close contact with the first cooling unit 80 (specifically, the front face part 822a of the heat pipe holding part 822). Preferably, the high-heat generating electric component 65 is fixed as described above for the purpose of facilitating heat exchange with the heat pipes 83.

However, the high-heat generating electric component 65 is not necessarily fixed to the first cooling unit 80 in close contact with the first cooling unit 80 as long as a cooling value to be required from the viewpoint of reliability is ensured. For example, the high-heat generating electric component 65 may be in partial contact with the first cooling unit 80. Alternatively, the high-heat generating electric component 65 may be thermally connected to the first cooling unit 80 with any object interposed between the high-heat generating electric component 65 and the first cooling unit 80 or may be cooled by cold radiation from the first cooling unit 80 at a position apart from the first cooling unit 80 as long as the high-heat generating electric component 65 is thermally connected to the first cooling unit 80 and ensures the required cooling value.

### (10-7) Modification 7

In the outdoor unit 10 according to the foregoing embodiment, the high-heat generating electric component 65 is lower in heightwise position than the outdoor fans 18 and higher in heightwise position than the fan controlling electric components 66. In this respect, the entire high-heat generating electric component 65 is not necessarily higher in heightwise position than the fan controlling electric components 66 so long as to produce the effect of "facilitating favorable cooling of both the high-heat generating electric component 65 configured to control the compressor and the fan controlling electric components 66 configured to control the outdoor fans 18 and thus suppressing decrease in reliability". In other words, the high-heat generating electric component 65 may be partially superimposed on the fan controlling electric components 66 as seen from the horizontal direction as long as there arises no contradiction as to the functions and effects described in Feature (9-1).

Likewise, the entire high-heat generating electric component 65 is not necessarily lower in heightwise position than the outdoor fans 18. In other words, the high-heat generating electric component 65 may be partially superimposed on the outdoor fans 18 as seen from the horizontal direction as long as there arises no contradiction as to the functions and effects described in Feature (9-1).

### (10-8) Modification 8

In the foregoing embodiment, each heat pipe 83 of the first cooling unit 80 is disposed with its longitudinal axis extending horizontally. In this respect, preferably, the heat pipes 83 are disposed as described above from the viewpoint of suppressing frost bursting as to the heat pipes 83. However, the heat pipes 83 are not necessarily disposed as described above as long as the reliability for frost bursting is ensured. For example, each heat pipe 83 may be disposed such that its longitudinal axis extends in a direction crossing the horizontal direction. Alternatively, each heat pipe 83 may be disposed such that its longitudinal axis extends vertically.

### (10-9) Modification 9

In the foregoing embodiment, the second fin pitch P2 is at least twice as long as the first fin pitch P1. However, the present invention is not limited thereto. The ratio between the first fin pitch P1 and the second fin pitch P2 may be appropriately changed in accordance with design specifications and installation environments as long as there arises no contradiction as to the functions and effects described in Feature (9-1). For example, the second fin pitch P2 may be at least 1.5 times as long as the first fin pitch P1. Alternatively, the second fin pitch P2 may be equal or less than the first fin pitch P1.

### (10-10) Modification 10

In the foregoing embodiment, the electric component box 50 includes the top face cover 53 spaced apart from the fifth openings 52e, located on the upper side of the electric component box 50, and configured to suppress the entry of liquid into the fifth openings 52e. In this respect, preferably, the top face cover 53 is disposed as described above in the foregoing embodiment from the viewpoint of suppressing the entry of liquid into the electric component box 50 through the fifth openings 52e. However, the top face cover 53 is not necessarily provided for the purpose of producing the effect of facilitating cooling of the high-heat generating electric component 65 and fan controlling electric components 66. The top face cover 53 may be omitted as long as the reliability for the entry of liquid into the electric component box 50 is ensured.

### (10-11) Modification 11

In the foregoing embodiment, the outdoor fans 18 are disposed near the upper end of the outdoor unit casing 40. However, the position of the outdoor fans 18 may be appropriately changed as long as there arises no contradiction as to the functions and effects described in Feature (9-1). For example, the outdoor fans 18 may be disposed at a heightwise position near a middle of the outdoor unit casing 40.

### (10-12) Modification 12

In the foregoing embodiment, the high-heat generating electric component 65 is a power module including a plurality of power devices. However, the high-heat generating electric component 65 is not necessarily limited thereto. For example, the high-heat generating electric component 65 may be any electric component as long as it generates heat when being energized.

### (10-13) Modification 13

In the foregoing embodiment, the configuration of the refrigerant circuit RC is not limited to that illustrated in FIG. 1, and may be appropriately changed in accordance with design specifications and installation environments. For example, the accumulator 11 and the outdoor expansion valve 16 may be appropriately omitted if they are not necessarily provided. In addition, the refrigerant circuit RC may additionally include a device (e.g., a receiver) not illustrated in FIG. 1.

### (10-14) Modification 14

In the foregoing embodiment, the present invention is applied to the air conditioning system 100 including one outdoor unit 10 and two indoor units 30 connected to the outdoor unit 10 in parallel via the connection pipes (LI, G1). However, a configuration of an air conditioning system to which the present invention is applied is not limited to this configuration. Specifically, as to an air conditioning system to which the present invention is applied, the number of outdoor units 10 and/or indoor units 30 and the connection of an outdoor unit 10 and an indoor unit 30 may be appropriately changed in accordance with installation environments and design specifications.

### (10-15) Modification 15

In the foregoing embodiment, the present invention is applied to the air conditioning system 100. However, the present invention is not limited thereto and is applicable to any refrigeration apparatus (e.g., a water heater, a heat pump chiller) including a refrigerant circuit and an outdoor unit as defined in the claims.

### INDUSTRIAL APPLICABILITY

The present invention is applicable to an outdoor unit for a refrigeration apparatus.

### REFERENCE SIGNS LIST

- 10, 10':: outdoor unit
- 12:: compressor
- 15:: outdoor heat exchanger
- 18:: outdoor fan (fan)
- 20:: outdoor unit control unit
- 30:: indoor unit
- 40, 40':: outdoor unit casing (casing)
- 41:: installation leg
- 43:: bottom frame
- 45:: support
- 47:: front face panel
- 47a:: first front face panel
- 47b:: second front face panel
- 49:: fan module
- 50:: electric component box (electric component box)
- 51:: front face cover
- 52:: main body frame
- 52a:: first opening
- 52b:: second opening
- 52c:: third opening
- 52d:: fourth opening
- 52e:: fifth opening (exhaust port)
- 52f:: sixth opening
- 53:: top face cover (cover part)
- 54:: first side face cover
- 55:: second side face cover
- 57:: first fitting
- 58:: second fitting
- 63:: compressor controlling electric component
- 65:: high-heat generating electric component (first heat generating component)
- 66:: fan controlling electric component (second heat generating component)
- 71:: control board
- 75:: board unit
- 75a:: compressor controlling electric component mount portion
- 75b:: fan controlling electric component mount portion
- 76:: compressor control board (first board)
- 77:: fan control board (second board)
- 80:: first cooling unit (first cooler)
- 81:: first cooling unit fin (heat radiating fin)
- 82:: first cooling unit main body (main body)
- 82a:: heat pipe insertion hole
- 83:: heat pipe
- 85:: second cooling unit (second cooler)
- 86:: second cooling unit fin (second heat radiating fin)
- 87:: second cooling unit main body
- 100:: air conditioning system (refrigeration apparatus)
- 401:: intake port
- 402:: blow-out port
- 501:: vertical plate
- 521:: rear face part
- 522:: left side face part
- 523:: right side face part
- 524:: top face part
- 531:: upper cover part
- 532:: left lateral cover part
- 533:: right lateral cover part
- 541:: right-side part
- 542:: front-side part
- 543:: rear-side part
- 544:: upper part
- 821:: fin holding part (first part)
- 822:: heat pipe holding part (second part)
- 822a:: front face part
- AF:: outdoor air flow (air flow)
- M12:: compressor motor
- M18:: outdoor fan motor
- P1:: first fin pitch
- P2:: second fin pitch
- RC:: refrigerant circuit
- SP:: inner space
- SP1:: lower space
- SP2:: upper space
- SP2a:: front-side upper space
- SP2b:: rear-side upper space

### CITATION LIST

### PATENT LITERATURE

Patent Literature 1: JP 2006-266547 A

## Claims

1. An outdoor unit (10, 10') for a refrigeration apparatus,
the outdoor unit (10, 10') comprising:
a fan (18) configured to provide an air flow (AF);
a casing (40, 40') housing therein the fan (18) and having a blow-out port (402) through which the air flow are blown;
a first heat generating component (65) configured to generate heat when being energized;
a first board (76) on which the first heat generating component (65) is mounted;
an electric component box (50) housing therein the first board (76); and
a first cooler (80) configured to cool the first heat generating component (65),
wherein
the first cooler (80) includes:
a plurality of first heat radiating fins (81) located on a flow path of the air flow (AF) and configured to exchange heat with the air flow (AF),
**characterized in that** the first cooler (80) further includes:
a heat pipe (83) in which a coolant for heat exchange with the first heat generating component (65) is sealed,
the heat pipe (83) being thermally connected to the first heat generating component (65);
and
a main body (82) interposed between the heat pipe (83) and the first heat radiating fins (81) to thermally connect the heat pipe (83) to the first heat radiating fins (81),
wherein the heat pipe (83) is located in the electric component box (50), and is adjacent to the first heat generating component (65),
wherein the heat pipe (83) is separated from a blowing space (S1), the blowing space (S1) being a space in the casing (40, 40') wherein a main flow path of the air flow (AF) is formed,
and wherein the heat pipe (83) is shielded from the air flow (AF) by the main body (82) of the first cooler (80),
and wherein
the electric component box (50) has a first opening (52a) from which the first heat radiating fins (81) are exposed,
the main body (82) has an area that is equal to or more than an area of the first opening,
and
the first cooler (80) is fixed to the electric component box (50) with each heat radiating fin protruding out of the electric component box (50) through the first opening and with the main body (82) closing the first opening.

2. The outdoor unit (10, 10') according to claim 1, wherein
the main body (82) includes:
a first part (821) interposed between the heat pipe (83) and the heat radiating fin to thermally connect the heat pipe (83) to the first heat radiating fins (81); and
a second part (822) interposed between the first heat generating component (65) and the heat pipe (83) to thermally connect the first heat generating component (65) to the heat pipe (83).

3. The outdoor unit (10, 10') according to claim 2, wherein
the first part is integrated with the second part.

4. The outdoor unit (10, 10') according any one of claims 1 to 3, wherein
the heat pipe (83) is disposed with its longitudinal axis extending horizontally.

5. The outdoor unit (10, 10') according to any one of claims 1 to 4, wherein
the first heat generating component (65) comprises a power device or a power module including the power device.

6. The outdoor unit (10, 10') according to any one of claims 1 to 5, further comprising:
a second heat generating component (66) configured to control a driven state of the fan;
a second board (77) on which the second heat generating component (66) is mounted; and
a second cooler (85) thermally connected to the second heat generating component (66) and configured to cool the second heat generating component (66),
wherein
the second cooler (85) includes a plurality of second heat radiating fins (86) configured to exchange heat with the air flow.

7. The outdoor unit (10, 10') according to claim 6, wherein
the first heat radiating fins (81) of the first cooler (80) are arranged with a first fin pitch (PI),
the second heat radiating fins (86) of the second cooler (85) are arranged with a second fin pitch (P2), and
the first fin pitch is shorter than the second fin pitch.

8. The outdoor unit (10, 10') according to claim 6 or 7, wherein
the first heat radiating fins (81) are lower in heightwise position than the fan and higher in heightwise position than the second heat radiating fins (86).

9. The outdoor unit (10, 10') according to any one of claims 1 to 8, wherein
the electric component box (50) has in its top face an exhaust port (52e) through which air is discharged, and
the exhaust port (52e) is lower in heightwise position than the fan and higher in heightwise position than the first heat radiating fins (81).

10. The outdoor unit (10, 10') according to claim 9, wherein
the electric component box (50) includes a cover part (53) spaced apart from the exhaust port (52e), located on an upper side of the electric component box (50), and configured to suppress entry of liquid into the exhaust port (52e).

## Patentansprüche

1. Außeneinheit (10, 10') für eine Kühlvorrichtung, wobei die Außeneinheit (10, 10') Folgendes umfasst:
ein Gebläse (18), das ausgelegt ist, um einen Luftstrom (AF) bereitzustellen;
ein Gehäuse (40, 40'), in dem das Gebläse (18) untergebracht ist und das einen Ausblasstutzen (402) aufweist, durch den der Luftstrom geblasen wird;
eine erste Wärmeerzeugungskomponente (65), die ausgelegt ist, um Wärme zu erzeugen, wenn sie mit Strom versorgt wird;
eine erste Platine (76), auf der die erste Wärmeerzeugungskomponente (65) montiert ist;
einen Elektrokomponentenkasten (50), in dem die erste Platine (76) untergebracht ist, und
einen ersten Kühler (80), der ausgelegt ist, um die erste Wärmeerzeugungskomponente (65) zu kühlen,
wobei der erste Kühler (80) Folgendes einschließt:
eine Vielzahl von ersten Wärmeabstrahlungsrippen (81), die an einem Strömungsweg des Luftstroms (AF) angeordnet und ausgelegt sind, um Wärme mit dem Luftstrom (AF) zu tauschen,
**dadurch gekennzeichnet, dass** der erste Kühler (80) zudem Folgendes einschließt:
ein Heizrohr (83), in dem ein Kältemittel für den Wärmetausch mit der ersten Wärmeerzeugungskomponente (65) dichtschließend enthalten ist,
wobei das Heizrohr (83) thermisch mit der ersten Wärmeerzeugungskomponente (65) verbunden ist;
und
einen Hauptkörper (82), der zwischen dem Heizrohr (83) und den ersten Wärmeabstrahlungsrippen (81) eingesetzt ist, um das Heizrohr (83) thermisch mit den ersten Wärmeabstrahlungsrippen (81) zu verbinden,
wobei das Heizrohr (83) im Elektrokomponentenkasten (50) angeordnet ist und an die erste Wärmeerzeugungskomponente (65) angrenzt,
wobei das Heizrohr (83) von einem Blasbereich (S1) getrennt ist, wobei es sich beim Blasbereich (S1) um einen Bereich im Gehäuse (40, 40') handelt, in dem ein Hauptströmungsweg des Luftstroms (AF) gebildet wird,
und wobei das Heizrohr (83) vom Luftstrom (AF) mittels des Hauptkörpers (82) des ersten Kühlers (80) abgeschirmt wird
und wobei der Elektrokomponentenkasten (50) eine erste Öffnung (52a) besitzt, aus der die ersten Wärmeabstrahlungsrippen (81) hervorstehen,
wobei der Hauptkörper (82) eine Fläche aufweist, die gleich oder größer einer Fläche der ersten Öffnung ist und
wobei der erste Kühler (80) am Elektrokomponentenkasten (50) fixiert ist, wobei eine jede Wärmeabstrahlungsrippe aus dem Elektrokomponentenkasten (50) durch die erste Öffnung herausragt und wobei der Hauptkörper (82) die erste Öffnung verschließt.

2. Außeneinheit (10, 10') nach Anspruch 1,
wobei der Hauptkörper (82) Folgendes einschließt:
einen ersten Teil (821), der zwischen dem Heizrohr (83) und der Wärmeabstrahlungsrippe eingesetzt ist, um das Heizrohr (83) thermisch mit den ersten Wärmeabstrahlungsrippen (81) zu verbinden, und
einen zweiten Teil (822), der zwischen der ersten Wärmeerzeugungskomponente (65) und dem Heizrohr (83) eingesetzt ist, um die erste Wärmeerzeugungskomponente (65) mit dem Heizrohr (83) zu verbinden.

3. Außeneinheit (10, 10') nach Anspruch 2, wobei der erste Teil mit dem zweiten Teil integriert ist.

4. Außeneinheit (10, 10') nach einem der Ansprüche 1 bis 3, wobei das Heizrohr (83) so angeordnet ist, dass sich seine Längsachse horizontal erstreckt.

5. Außeneinheit (10, 10') nach einem der Ansprüche 1 bis 4, wobei die erste Wärmeerzeugungskomponente (65) ein Stromaggregat oder ein Strommodul, einschließend das Stromaggregat, umfasst.

6. Außeneinheit (10, 10') nach einem der Ansprüche 1 bis 5, zudem umfassend:
eine zweite Wärmeerzeugungskomponente (66), die ausgelegt ist, um einen angetriebenen Zustand des Gebläses zu steuern;
eine zweite Platine (77), auf der die zweite Wärmeerzeugungskomponente (66) montiert ist, und
einen zweiten Kühler (85), der thermisch mit der zweiten Wärmeerzeugungskomponente (66) verbunden und ausgelegt ist, um die zweite Wärmeerzeugungskomponente (66) zu kühlen,
wobei der zweite Kühler (85) eine Vielzahl von zweiten Wärmeabstrahlungsrippen (86) einschließt, die ausgelegt sind, um Wärme mit dem Luftstrom zu tauschen.

7. Außeneinheit (10, 10') nach Anspruch 6,
wobei die ersten Wärmeabstrahlungsrippen (81) des ersten Kühlers (80) mit einem ersten Rippenabstand (P1) angeordnet sind,
die zweiten Wärmeabstrahlungsrippen (86) des zweiten Kühlers (85) mit einem zweiten Rippenabstand (P2) angeordnet sind und
der erste Rippenabstand kleiner ist als der zweite Rippenabstand.

8. Außeneinheit (10, 10') nach Anspruch 6 oder 7, wobei die ersten Wärmeabstrahlungsrippen (81) höhenmäßig niedriger positioniert sind als das Gebläse und höhenmäßig höher positioniert sind als die zweiten Wärmeabstrahlungsrippen (86).

9. Außeneinheit (10, 10') nach einem der Ansprüche 1 bis 8,
wobei der Elektrokomponentenkasten (50) an seiner oberseitigen Seitenfläche einen Abluftstutzen (52e) aufweist, durch den Luft abgeführt wird, und
der Abluftstutzen (52e) höhenmäßig niedriger positioniert ist als das Gebläse und höhenmäßig höher positioniert ist als die ersten Wärmeabstrahlungsrippen (81) .

10. Außeneinheit (10, 10') nach Anspruch 9, wobei der Elektrokomponentenkasten (50) einen Abdeckungsteil (53) einschließt, der vom Abluftstutzen (52e) beabstandet und an einer oberen Seite des Elektrokomponentenkastens (50) angeordnet und ausgelegt ist, um das Eintreten von Flüssigkeit in den Abluftstutzen (52e) zu unterbinden.

## Revendications

1. Unité extérieure (10, 10') pour dispositif de réfrigération,
l'unité extérieure (10, 10') comprenant :
un ventilateur (18) configuré pour fournir un flux d'air (AF) ;
un boîtier (40, 40') logeant à l'intérieur le ventilateur (18) et ayant un orifice de soufflage (402) à travers lequel le flux d'air est soufflé ;
un premier composant générateur de chaleur (65) configuré pour générer de la chaleur lorsqu'il est mis sous tension ;
une première carte (76) sur laquelle le premier composant générateur de chaleur (65) est monté ;
un boîtier de composants électriques (50) logeant à l'intérieur la première carte (76) ; et
un premier refroidisseur (80) configuré pour refroidir le premier composant générateur de chaleur (65),
dans lequel le premier refroidisseur (80) inclut :
une pluralité de premières ailettes de rayonnement de chaleur (81) situées sur un trajet d'écoulement du flux d'air (AF) et configurées pour échanger de la chaleur avec le flux d'air (AF),
**caractérisée en ce que** le premier refroidisseur (80) inclut en outre :
un tuyau de chaleur (83) dans lequel un réfrigérant pour l'échange de chaleur avec le premier composant générateur de chaleur (65) est scellé,
le tuyau de chaleur (83) étant connecté thermiquement au premier composant générateur de chaleur (65) ;
et
un corps principal (82) interposé entre le tuyau de chaleur (83) et les premières ailettes de rayonnement de chaleur (81) pour relier thermiquement le tuyau de chaleur (83) aux premières ailettes de rayonnement de chaleur (81),
dans lequel le tuyau de chaleur (83) est situé dans le boîtier de composant électrique (50), et est adjacent au premier composant générateur de chaleur (65), dans lequel le tuyau de chaleur (83) est séparé d'un espace de soufflage (S1), l'espace de soufflage (S1) étant un espace dans le boîtier (40, 40') dans lequel un trajet d'écoulement principal du flux d'air (AF) est formé,
et dans lequel le tuyau de chaleur (83) est protégé du flux d'air (AF) par le corps principal (82) du premier refroidisseur (80),
et dans lequel le boîtier de composants électriques (50) a une première ouverture (52a) à partir de laquelle les premières ailettes de rayonnement de chaleur (81) sont exposées,
le corps principal (82) a une surface qui est égale ou supérieure à une surface de la première ouverture, et le premier refroidisseur (80) est fixé au boîtier de composants électriques (50) avec chaque ailette de rayonnement de chaleur dépassant du boîtier de composants électriques (50) à travers la première ouverture et avec le corps principal (82) fermant la première ouverture.

2. Unité extérieure (10, 10') selon la revendication 1, dans laquelle le corps principal (82) inclut :
une première partie (821) interposée entre le tuyau de chaleur (83) et l'ailette de rayonnement de chaleur pour connecter thermiquement le tuyau de chaleur (83) aux premières ailettes de rayonnement de chaleur (81) ; et
une seconde partie (822) interposée entre le premier composant générateur de chaleur (65) et le tuyau de chaleur (83) pour connecter thermiquement le premier composant générateur de chaleur (65) au tuyau de chaleur (83) .

3. Unité extérieure (10, 10') selon la revendication 2, dans laquelle la première partie est intégrée à la seconde partie.

4. Unité extérieure (10, 10') selon l'une quelconque des revendications 1 à 3, dans laquelle le tuyau de chaleur (83) est disposé avec son axe longitudinal s'étendant horizontalement.

5. Unité extérieure (10, 10') selon l'une quelconque des revendications 1 à 4, dans laquelle le premier composant générateur de chaleur (65) comprend un dispositif de puissance ou un module de puissance incluant le dispositif de puissance.

6. Unité extérieure (10, 10') selon l'une quelconque des revendications 1 à 5, comprenant en outre :
un second composant générateur de chaleur (66) configuré pour commander un état entraîné du ventilateur ;
une seconde carte (77) sur laquelle le second composant générateur de chaleur (66) est monté ; et
un second refroidisseur (85) connecté thermiquement au second composant générateur de chaleur (66) et configuré pour refroidir le second composant générateur de chaleur (66),
dans lequel le second refroidisseur (85) inclut une pluralité de secondes ailettes de rayonnement de chaleur (86) configurées pour échanger de la chaleur avec le flux d'air.

7. Unité extérieure (10, 10') selon la revendication 6, dans laquelle les premières ailettes de rayonnement de chaleur (81) du premier refroidisseur (80) sont disposées avec un premier pas d'ailette (P1),
les secondes ailettes de rayonnement de chaleur (86) du second refroidisseur (85) sont disposées avec un second pas d'ailette (P2), et
le premier pas d'ailette est plus court que le second pas d'ailette.

8. Unité extérieure (10, 10') selon la revendication 6 ou 7, dans laquelle les premières ailettes de rayonnement de chaleur (81) sont plus basses en position de hauteur que le ventilateur et plus hautes en position de hauteur que les secondes ailettes de rayonnement de chaleur (86) .

9. Unité extérieure (10, 10') selon l'une quelconque des revendications 1 à 8,
dans laquelle le boîtier de composants électriques (50) présente dans sa face supérieure un orifice d'évacuation (52e) par lequel l'air est évacué, et
l'orifice d'évacuation (52e) est plus bas en position de hauteur que le ventilateur et plus haut en position de hauteur que les premières ailettes de rayonnement de chaleur (81).

10. Unité extérieure (10, 10') selon la revendication 9, dans laquelle le boîtier de composants électriques (50) inclut une partie de couverture (53) éloignée de l'orifice d'échappement (52e), située sur un côté supérieur du boîtier de composants électriques (50), et configurée pour supprimer l'entrée de liquide dans l'orifice d'échappement (52e).
